# EUROPEAN PATENT APPLICATION

(11) **EP 2 397 790 A2**
(43) Date of publication of application: **21.12.2011**
(21) Application number: 11151742.1
(22) Date of filing: 10.06.2009
(51) Int. Cl.: F24J 2/42, H01L 35/00, H01L 35/30

(54) **Integrated energy system for whole home or building**

(30) Priority: 10.06.2008 US 60377
(62) Divisional of application: 09763508.0
(71) Applicant: Watts, Phillip C., Longmont, CO 80501 (US)
(72) Inventor: Watts, Phillip C., Longmont, CO 80501 (US)
(74) Representative: Gill, David Alan

(57) **Abstract**

A thermoelectric generator includes a plurality of thermoelectric modules that generate electrical power when subjected to a temperature differential. The generator also includes a plurality of first thermal elements to which heat is supplied by a first fluid and a plurality of second thermal elements from which heat is removed by a second fluid. The first and second thermal elements are arranged in a stack of alternating first and second thermal elements having one of the plurality of thermoelectric modules between each adjacent pair of first and second thermal elements. Each thermoelectric module is in contact on its first side with one of the first thermal elements and in contact on its second side with one of the second thermal elements such that no face of any thermal element contacts more than one of the thermoelectric modules.

## Description

This application claims priority to U.S. provisional application 61/060,377, filed June 10, 2008 and titled "Combined Heat and Power and Hydrogen Generation for Whole Home or Building with Ground Heat Exchanger Using Thermoelectric Seebeck Modules," the entire disclosure of which is hereby incorporated by reference herein for all purposes. Provisional U.S. Patent Application 60/306,274, titled "Combination outdoor portable heating pad and electricity generator" is also hereby incorporated by reference herein for all purposes.

### BACKGROUND OF THE INVENTION

A typical home or other building includes several energy systems. For example, the building maybe connected to the mains power grid and receive electrical power generated at a remote power plant. The building may be supplied with natural gas for space and water heating. Many of these traditional energy systems depend on non-renewable and ever-more-expensive fossil fuels.

Alternative energy systems have been proposed. However, prior alternative energy systems have evolved piecemeal. Furthermore, many alternative electrical systems rely on photovoltaic cells to generate electricity from sunlight, and store the resulting electrical energy in batteries. While the day-to-day operating cost of a photovoltaic system is low, these systems typically have a high installation cost, and the batteries have a finite life, requiring expensive periodic replacements. Battery systems also are typically oversized, as the life of the batteries is optimized by avoiding discharges of more than 20 percent of the stored energy from the batteries.

### BRIEF SUMMARY OF THE INVENTION

In one embodiment, an integrated energy system for a building comprises at least one reservoir of thermal energy, at least one solar collector that provides heat to the reservoir, and at least one environment-coupled piping loop through which a cooling fluid is circulated such that heat is exhausted from the cooling fluid to the environment. The system further comprises a thermoelectric generator that generates electric power from a temperature differential between the reservoir of thermal energy and the cooling fluid, and at least one hydronic heating unit through which heated fluid is piped, providing space heating to at least one space in the building, the heated fluid deriving its heat from the reservoir of thermal energy. The system may also comprise at least one hydronic cooling loop through which at least some of the cooling fluid is piped, providing space cooling to at least one space in the building. In some embodiments, the system further comprises a backup heater that provides heat to the reservoir of thermal energy, supplementing the solar collector. The backup heater may derive heat from a fossil fuel.

In some embodiments, the system comprises a tank of hot water designated for domestic hot water use. The system may further comprise a backup domestic water heater that supplies heat to water designated for domestic hot water use when insufficient energy is otherwise available. The backup domestic water heater may comprise at least one on-demand heater. The backup domestic water heater may derive heat from a fossil fuel.

In some embodiments, the system further comprises a direct-current power grid within the building. In some embodiments, the system includes an inverter that converts direct-current power from the thermoelectric generator to alternating-current power.

In some embodiments, the thermoelectric generator comprises a plurality of banks, and the integrated energy system further comprises a thermoelectric generator controller and a matrix switch that, under control of the thermoelectric generator controller, configures the interconnection of the banks.

In some embodiments, the system further comprises a load controller that at least temporarily prevents the operation of at least one load based in part on the amount of electrical power being consumed by other loads. In some embodiments, the system comprises a backup connection to the mains power grid, the backup connection providing electrical power to the building to supplement the thermoelectric generator.

In some embodiments, the system includes a hydrogen generator powered by electricity from the thermoelectric generator. The system may also include a backup domestic water heater, wherein the backup domestic water heater derives heat from hydrogen generated by the hydrogen generator.

In some embodiments, the reservoir of thermal energy comprises a tank of heated water. A medium in the reservoir of thermal energy may be heated directly by the solar collector. The medium in the reservoir of thermal energy may be heated though a heat exchanger carrying a second medium heated by the solar collector.

In some embodiments, the heated fluid circulated through the at least one hydronic heating unit derives its heat from the reservoir of thermal energy through a heat exchanger. The at least one environment-coupled piping loop may comprise a deep earth-coupled piping loop. The at least one environment-coupled piping loop may comprise a shallow earth-coupled piping loop. The at least one environment-coupled piping loop may comprise an air-coupled piping loop.

In another embodiment, a method of operating an energy system in a building comprises, heating a reservoir of thermal energy using a solar collector. Heated fluid that derives its heat from the reservoir of thermal energy is circulated through a hydronic heating loop, providing space heating to at least one space in the building. A cooling fluid is circulated through an environment-coupled piping loop such that heat is exhausted from the cooling fluid to the environment, and electrical power is generated a thermoelectric generator subjected to a temperature differential between reservoir and the cooling fluid.

In some embodiments, the method further comprises circulating at least some of the cooling fluid through a hydronic cooling loop, providing space cooling to at least one space in the building. The method may comprise generating hydrogen using electrical energy generated by the thermoelectric generator. In some embodiments, the method comprises storing, separately from the reservoir of thermal energy, water designated for domestic hot water use. In some embodiments, the method further comprises heating the water designated for domestic hot water use with heat from the reservoir of thermal energy. In some embodiments, the method comprises dynamically configuring, using a thermoelectric generator controller, interconnections of thermoelectric modules within the thermoelectric generator. In some embodiments, the method comprises temporarily preventing the operation of at least one electrical load based in part on the amount of electrical power being consumed by other loads. In some embodiments, circulating the cooling fluid through and environment-coupled piping loop comprises circulating the cooling fluid through and earth-coupled piping loop.

In one embodiment, an apparatus for automatically configuring a thermoelectric power generation system in accordance with the requirements of a load includes a thermoelectric generator that generates electric power when subjected to a temperature differential, and at least one configurable component that affects at least one aspect of the power generated by the thermoelectric generator. A monitor senses at least one aspect of the power generated by the thermoelectric generator and provides at least one signal characterizing the power generated by the thermoelectric generator. A controller is configured to receive the at least one signal and configure the at least one configurable component based on the at least one signal in accordance with the requirements of a load to which power is supplied by the thermoelectric generator. The controller may include a microprocessor and a memory holding instructions executable by the microprocessor to receive the at least one signal and configure the at least one configurable component based on the at least one signal in accordance with the requirements of a load to which power is supplied by the thermoelectric generator.

The temperature differential may be provided by a supply of heated fluid and a relatively cold sink, and the at least one configurable component may include a valve that, under control of the controller, adjusts a flow rate of the heated fluid. The temperature differential may be provided by a supply of heated fluid and a relatively cold sink, and the at least one configurable component may include a valve that, under control of the controller, adjusts the temperature of the heated fluid. The temperature differential may be provided by a relatively hot source and a supply of relatively cold fluid, and the at least one configurable component may include a valve that, under control of the controller, adjusts a flow rate of the relatively cold fluid. The temperature differential may be provided by a relatively hot source and a supply of relatively cold fluid, and the at least one configurable component may include a valve that, under control of the controller, adjusts the temperature of the relatively cold fluid.

The temperature differential may be provided by a supply of fluid heated by a solar collector, and the at least one configurable component may include a solar collector adjusting mechanism that adjusts the ability of the solar collector to impart heat to the heated fluid. The solar collector may be a flat panel solar collector, and the solar collector adjusting mechanism may adjust the position of a shade over the flat panel solar collector. The solar collector may be a concentrating solar collector, and the solar collector adjusting mechanism may adjust the aiming or focus of the concentrating solar collector.

The controller may be further configured to produce a second signal indicating a status of power being generated by the thermoelectric generator. The second signal may indicate the amount of power the thermoelectric generator is producing. The second signal may indicate that the thermoelectric generator is unable to produce power in accordance with the requirements of the load.

The thermoelectric generator may comprise at least two banks, each bank including at least one thermoelectric module, each bank producing a portion of the power produced by the thermoelectric generator. The at least one configurable component may include a matrix switch that, under control of the controller, configures the interconnection of the banks. Configuring the interconnection of the banks may include disconnecting at least one bank. Configuring the interconnection of the banks may include placing at least one bank in series with at least one other bank. Configuring the interconnection of the banks may include placing at least one bank in parallel with at least one other bank. Configuring the interconnection of the banks may include placing banks in a combination of series and parallel connections. Configuring the interconnection of the banks may include configuring the interconnection of the banks to maintain a desired output voltage for the thermoelectric generator.

Each bank may include at least two thermoelectric modules, each thermoelectric module producing a portion of the power produced by its respective bank. The at least one configurable component may include a matrix switch that, under control of the controller, configures the interconnection of the modules within a bank. In some embodiments, the thermoelectric generator comprises at least two banks, wherein each bank produces a portion of the power produced by the thermoelectric generator; each bank comprises at least two thermoelectric modules, wherein each thermoelectric module produces a portion of the power produced by its respective bank; each bank comprises a module-level matrix switch that, under control of the controller, configures the interconnection of modules within its respective bank; and the apparatus further comprises a bank-level matrix switch that, under control of the controller, configures the interconnection of the banks.

In another embodiment, a method of automatically configuring a thermoelectric power generation system in accordance with the requirements of a load comprises receiving, by a controller, at least one signal characterizing the power generated by a thermoelectric generator that generates electric power when subjected to a temperature differential, and receiving, by the controller, an indication of requirements of a load to which power is supplied by the thermoelectric generator. The method further comprises configuring, by the controller based on the at least one signal characterizing the power generated by the thermoelectric generator and based on the indication of the requirements of the load to which power is supplied by the thermoelectric generator, at least one configurable component that affects at least one aspect of the power generated by the thermoelectric generator.

The temperature differential may be provided by a heated fluid and a relatively cold sink, and configuring the at least one configurable component may include adjusting a valve that adjusts a rate of flow of the heated fluid. The temperature differential may be provided by a heated fluid and a relatively cold sink, and configuring the at least one configurable component further may include adjusting a valve that adjusts the temperature of the heated fluid. The temperature differential may be provided by a supply of heated fluid and a relatively cold sink, wherein the supply of heated fluid is heated by a solar collector, and configuring the at least one configurable component may include adjusting the ability of the solar collector to impart heat to the heated fluid.

The thermoelectric generator may include at least two banks, each bank comprising at least one thermoelectric module, each bank producing a portion of the power produced by the thermoelectric generator, and configuring the at least one configurable component may further include controlling a matrix switch to configure the interconnection of the banks. The thermoelectric generator may include at least two thermoelectric modules, each module producing a portion of the power produced by the thermoelectric generator, and configuring the at least one configurable component may further comprise controlling a matrix switch to configure the interconnection of the thermoelectric modules. The thermoelectric generator may include at least two banks, each bank comprising at least two thermoelectric modules, wherein each bank produces a portion of the power produced by the thermoelectric generator, wherein each thermoelectric module produces a portion of the power produced by its respective bank, and configuring the at least one configurable component may further comprise controlling a module-level matrix switch to configure the interconnection of at least two of the thermoelectric modules, and controlling a bank-level matrix switch to configure the interconnection of the banks.

In another embodiment, a method of converting thermal energy stored in a reservoir of heated fluid to electrical energy includes passing heated fluid from the reservoir to a hot side of a thermoelectric generator and cooling a cold side of the thermoelectric generator. The thermoelectric generator includes a plurality of thermoelectric modules. The method further includes monitoring an output voltage produced by the thermoelectric generator, and reconfiguring interconnections of the thermoelectric modules to maintain the output voltage within a desired range as the temperature of the heated fluid fluctuates.

The method may also include heating the heated fluid using a solar collector. The plurality of thermoelectric modules may be grouped into banks, and reconfiguring interconnections of the thermoelectric modules to maintain the output voltage within a desired range may include reconfiguring interconnections of the banks.

In another embodiment, a system for maintaining a power characteristic within a predetermined range include a monitor that measures a characteristic of power being supplied to a load by a thermoelectric generator, and a controller that receives a signal from the monitor. The signal communicates the measurement of the power characteristic, and the controller also includes a specification of a predetermined desired range for the power characteristic. The system also includes a matrix switch having a plurality of input connections, the input terminals receiving connections from a plurality of thermoelectric modules within the thermoelectric generator, and the matrix switch further comprising a set of output terminals through which power generated by the thermoelectric generator is delivered to the load. The controller is configured to compare the measurement of the power characteristic with the predetermined range, and to reconfigure interconnections between the input terminals and the output terminals to keep the power characteristic within the predetermined range. The predetermined characteristic may be a voltage. The controller further may include a microprocessor executing instructions stored on a computer-readable medium.

In one embodiment, a thermoelectric generator for generating electrical power from a difference in temperature includes a plurality of thermoelectric modules. Each thermoelectric module has a first side and a second side, and each thermoelectric module generates electrical power when subjected to a temperature differential between its respective first side and second side. The thermoelectric generator also includes a plurality of first thermal elements to which heat is supplied by a first fluid, and a plurality of second thermal elements from which heat is removed by a second fluid. The first and second thermal elements are arranged in a stack of alternating first and second thermal elements having one of the plurality of thermoelectric modules between each adjacent pair of first and second thermal elements. Each thermoelectric module is in contact on its first side with one of the first thermal elements and in contact on its second side with one of the second thermal elements such that no face of any thermal element contacts more than one of the thermoelectric modules. Each of the first and second thermal elements may be a block made of a thermally conductive material, and each block may further comprises a passageway through the block through which the respective fluid flows. The thermally conductive material may be aluminum. Each block may be generally rectangular, and each passageway may traverse its respective block generally diagonally. Each passageway may include a lead-in portion at each end, each lead-in portion being generally cylindrical and of a larger dimension than the midportion of the passageway. The first and second thermal elements may be mechanically interchangeable.

In some embodiments, the thermoelectric generator further comprises a clamp that holds the stack of thermoelectric modules and first and second thermal elements in compression. In some embodiments, the thermoelectric generator comprises a first fluid inlet manifold that distributes the first fluid to the first thermal elements, and a first fluid outlet manifold that collects the first fluid from the first thermal elements. In some embodiments the thermoelectric generator further comprises a second fluid inlet manifold that distributes the second fluid to the second thermal elements, and a second fluid outlet manifold that collects the second fluid from the second thermal elements. In some embodiments, the thermoelectric generator comprises a first fluid inlet manifold that distributes the first fluid to the first thermal elements, a first fluid outlet manifold that collects the first fluid from the first thermal elements, a second fluid inlet manifold that distributes the second fluid to the second thermal elements, and a second fluid outlet manifold that collects the second fluid from the second thermal elements. The first fluid inlet manifold and the second fluid outlet manifold may be positioned adjacent each other on one side of the stack of thermoelectric modules and first and second thermal elements.

In some embodiments, the thermoelectric generator further comprises one or more flexible tubes, at least one of the tubes connecting each of the manifolds with each of its respective first or second thermal elements. At least one of the flexible tubes may be press fit into its respective manifold and thermal element. The first fluid may be water. The second fluid may be water.

In another embodiment, a method of fabricating a thermoelectric generator for generating electrical power from a difference in temperature comprises providing a plurality of thermoelectric modules, each thermoelectric module having a first side and a second side, and each thermoelectric module generating electrical power when subjected to a temperature differential between its respective first side and second side. The method further comprises providing a plurality of first thermal elements configured to receive heat from a first fluid, and providing a plurality of second thermal elements configured to be cooled by a second fluid. The first and second thermal elements are arranged in a stack of alternating first and second thermal elements having one of the thermoelectric modules between each adjacent pair of first and second thermal elements. Each thermoelectric module is in contact on its first side with one of the first thermal elements and is in contact on its second side with one of the second thermal elements such that no face of any thermal element contacts more than one of the thermoelectric modules. In some embodiments, the method further comprises providing a first fluid inlet manifold configured to receive the first fluid and distribute it to the plurality of first thermal elements. The method may further comprise providing a second fluid inlet manifold configured to receive the second fluid and distribute it to the plurality of second thermal elements. The method may further comprise providing a first fluid outlet manifold configured to receive the first fluid from the plurality of first thermal elements and carry the first fluid away from the thermoelectric generator. The method may further comprise providing a second fluid outlet manifold configured to receive the second fluid from the plurality of second thermal elements and carry the second fluid away from the thermoelectric generator. The method may further comprise connecting each thermal element to a fluid inlet manifold and to a fluid outlet manifold. The method may further comprise clamping the stack of first thermal elements, second thermal elements, and thermoelectric modules, so that that stack is held in compression.

### BRIEF DESCRIPTION OF THE DRAWINGS

Figure 1 shows an integrated energy system for a building in accordance with a first embodiment.

Figure 2 shows a portion of the system of Figure 1 in greater detail, in accordance with another embodiment.

Figure 3 shows a schematic diagram of the operation of a thermoelectric module.

Figure 4 illustrates a system in accordance with an embodiment of the invention.

Figure 5 illustrates a system in accordance with another embodiment.

Figure 6 illustrates an embodiment of a configurable component.

Figure 7 illustrates an embodiment that uses solar energy for heating a fluid supplied to a thermoelectric generator.

Figure 8 illustrates an embodiment in which the output of a thermoelectric generator is adjusted electrically.

Figure 9 illustrates an example interconnection of banks in a thermoelectric generator.

Figure 10 illustrates another example interconnection of banks in a thermoelectric generator.

Figure 11 illustrates another example interconnection of banks in a thermoelectric generator.

Figure 12 illustrates the operation of a matrix switch.

Figure 13 shows the matrix switch of Figure 12 configured to place banks in the arrangement shown schematically in Figure 9.

Figure 14 shows the matrix switch of Figure 12 configured to place banks in the arrangement shown schematically in Figure 10.

Figure 15 shows the matrix switch of Figure 12 configured to place banks in the arrangement shown schematically in Figure 11.

Figure 16 illustrates a system in accordance with another embodiment, including both module-level matrix switches and a bank-level matrix switch.

Figure 17 illustrates a flowchart of a method in accordance with an embodiment of the invention.

Figure 18 shows one example arrangement for supplying a temperature differential to a single thermoelectric module.

Figure 19 shows one possible consequence of placing two thermoelectric modules of different heights between a single hot thermal element and a single cold thermal element.

Figure 20 illustrates a thermoelectric generator in accordance with an example embodiment of the invention.

Figure 21 shows a schematic view of a thermoelectric generator in accordance with another embodiment.

Figure 22 shows an oblique view of the thermoelectric generator of Figure 21.

Figure 23 shows an oblique view of a thermal element, in accordance with an embodiment.

Figure 24 shows the thermal element of Figure 23 in cross section.

Figure 25 illustrates a thermal element in accordance with another embodiment.

Figures 26A and 26B illustrate a method of making connections between flexible tubes and thermal elements, in accordance with an embodiment.

Figures 27A-27D illustrate several ways of making manifolds, according to embodiments of the invention.

Figure 28 illustrates a thermoelectric generator in accordance with another example embodiment.

Figure 29 illustrates a thermoelectric generator in accordance with still another example embodiment.

Figure 30 illustrates the use of a thermoelectric generator in a system wherein one fluid is heated using solar energy, and another fluid is cooled using an earth-coupled piping loop.

### DETAILED DESCRIPTION OF THE INVENTION

An integrated energy system for a home or other building utilizes a heated reservoir for energy storage. The reservoir is mainly heated by one or more solar collectors. The system also includes at least one environment-coupled piping loop through which a cooling fluid is circulated such that heat is exhausted from the cooling fluid to the environment. The thermal energy from the reservoir and the cooling fluid are then used in an integrated set of systems that provide space heating, space cooling, and electrical generation. Electricity is generated by a thermoelectric generator that exploits the temperature differential between the reservoir and the cooling fluid. The system may include heating and storage for domestic hot water, and may use excess power for hydrogen production. Backup heating and electrical systems may be provided for.

The ensuing description provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment. It being understood that various changes may be made in the function and arrangement of elements without departing from the spirit and scope as set forth in the appended claims.

Specific details are given in the following description to provide a thorough understanding of the embodiments. However, it will be understood by one of ordinary skill in the art that the embodiments may be practiced without these specific details. For example, circuits may be shown in block diagrams in order not to obscure the embodiments in unnecessary detail. In other instances, well-known circuits, processes, algorithms, structures, and techniques may be shown without unnecessary detail in order to avoid obscuring the embodiments.

Also, it is noted that the embodiments may be described as a process which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed, but could have additional steps not included in the figure. A process may correspond to a method, a function, a procedure, a subroutine, a subprogram, etc. When a process corresponds to a function, its termination corresponds to a return of the function to the calling function or the main function.

The term "machine-readable medium" includes, but is not limited to portable or fixed storage devices, optical storage devices, wireless channels and various other mediums capable of storing, containing or carrying instruction(s) and/or data. A code segment or machine-executable instructions may represent a procedure, a function, a subprogram, a program, a routine, a subroutine, a module, a software package, a class, or any combination of instructions, data structures, or program statements. A code segment may be coupled to another code segment or a hardware circuit by passing and/or receiving information, data, arguments, parameters, or memory contents. Information, arguments, parameters, data, etc. may be passed, forwarded, or transmitted via any suitable means including memory sharing, message passing, token passing, network transmission, etc.

Furthermore, embodiments may be implemented by hardware, software, firmware, middleware, microcode, hardware description languages, or any combination thereof. When implemented in software, firmware, middleware or microcode, the program code or code segments to perform the necessary tasks may be stored in a machine readable medium. A processor(s) may perform the necessary tasks.

Prior alternative energy systems have evolved piecemeal. For example, in a typical "solar" home, electricity generation is provided by photovoltaic cells with battery storage, while domestic hot water is provided by direct solar heating of water. Space heating may be enhanced by passive solar design techniques, with supplemental backup provided by burning natural gas, propane, wood, or another fuel. Space cooling may or may not be provided. This piecemeal approach to building energy management is complex and involves many design capacity of the system. At present, many square meters of collector area may be needed to provide sufficient electrical generation capacity in system **100**, but it is anticipated that future improvements in the efficiency of thermoelectric materials will reduce the required collector area dramatically.

The fluid in tube **103** is heated and is circulated by a pump (not shown), carrying thermal energy to a reservoir of thermal energy **105.** The working fluid in tube **103** may be water, a natural or synthetic oil, or another kind of fluid. Reservoir **105** contains a storage medium. The medium may simply be water. If water from reservoir **145** is also circulated through tube **103,** then the water is heated directly by solar collector **101.** Alternatively, the medium in reservoir **105** may be heated indirectly, for example through a heat exchanger. For example, if the working fluid in tube **103** is an oil and the storage medium in reservoir **105** is water, the water may take heat from the oil through a heat exchanger. If the storage medium in reservoir **105** is water, it is estimated that a 1000 gallon reservoir will be sufficient for a typical residential application. Preferably, the pump circulating the fluid in tube **103** operates only as necessary to maintain the temperature of reservoir **105.** For example, the pump may be turned off at night when no effective fluid heating is available from solar collector **101.**

The storage medium in reservoir **105** may be another kind of medium. In some embodiments, the medium in reservoir **105** may be a phase-change medium such as Glauber's salt, which efficiently stores thermal energy by virtue of a phase change from solid to liquid. Other media, including other phase change media, may be used.

Reservoir **105** provides simple, reliable, maintenance free energy storage for the system. The storage medium need not be changed or serviced, as would be the case with batteries.

Thermal energy from reservoir **105** may be used directly or indirectly for various heating needs in the building. For example, if the medium in reservoir **105** is water, water could be drawn from reservoir **105** for domestic hot water use. In that case, reservoir **105** would be replenished with additional supply water as needed to replace that drawn off for use. For the purposes if this disclosure, "domestic hot water" is heated water used for washing, bathing, cooking, or other processing or the like, whether system **100** is installed in a home, business, or industrial setting. Domestic water is typically discarded to a sanitary sewer after use. "Supply water" is water from an external water supply, such as a municipal water utility, a local well, or other source.
different technologies. Electricity generation by photovoltaics requires different solar collectors than those used for water heating, and requires expensive batteries that require periodic replacement. The batteries are typically oversized, in order to maximize their useful life by avoiding deep discharges.

Embodiments of the present invention exploit efficiencies made possible by integrating the various energy systems in a building. A single solar collector (or collector array) heats a reservoir of thermal energy. The reservoir of thermal energy may be a simple tank of heated water that stores thermal energy by virtue of the elevated temperature of the water. In other embodiments, the reservoir of thermal energy may comprise another medium, for example a eutectic or phase change medium such as Glauber's salt that stores energy primarily in the change of the salt between solid and liquid phases.

The reservoir of thermal energy is used for multiple purposes in the system. The thermal energy may be used directly for space and domestic water heating. Electricity generation is provided by a thermoelectric generator, using the elevated temperature of the reservoir as the "hot" side of a temperature differential exploited by the thermoelectric generator. The other "cold" side of the temperature differential is provided by a cooling fluid, preferably water, circulated through an environment-coupled piping loop that cools the fluid via its thermal contact with the earth or atmosphere. The cooling fluid may also be used for hydronic space cooling.

The advantages of such a system will be apparent to one of skill in the art. Energy storage is provided by a single reservoir, which may be as simple as a tank of water. No harsh or dangerous chemicals are needed for energy storage, and no expensive battery replacement is ever needed. Space heating, domestic water heating, and electrical generation are powered by a single solar collector or array of collectors. Space cooling comes as a by-product of electrical generation. Such a system is simpler, less expensive, and more flexible than the traditional piecemeal approach to alternative energy systems.

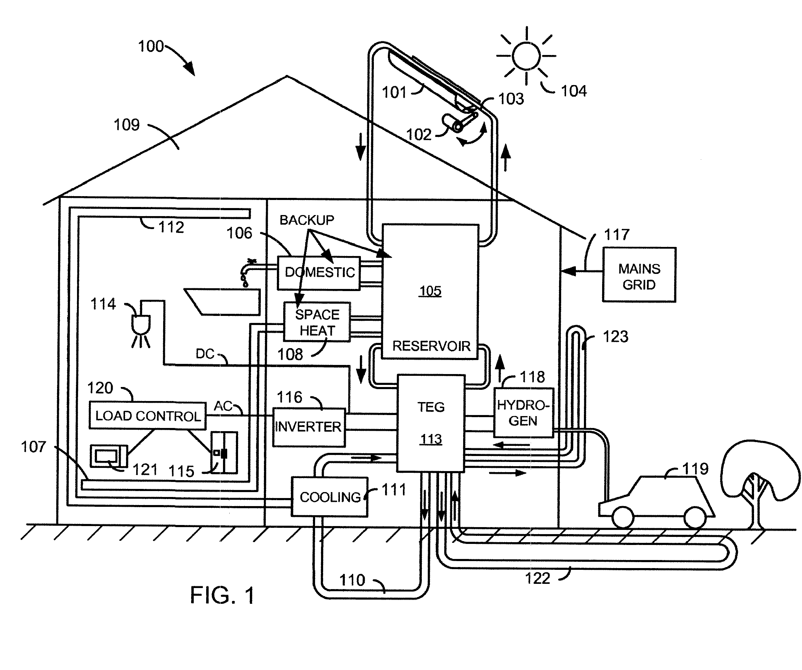

**Figure 1** shows an integrated energy system **100** for a building **109** in accordance with a first embodiment. In example system **100,** a solar collector **101** heats fluid in a tube **103,** using energy from the sun **104.** In this example, solar collector **101** is a concentrating type solar collector, for example a parabolic trough that concentrates solar radiation on tube **103** and tracks the motion of the sun under control of a motor **102.** One of skill in the art will recognize that other kinds of solar collectors may be used, including flat panel collectors or heat pipe collectors. One collector or an array of collectors may be used, depending on the

Preferably, especially where a medium other than water is used in reservoir **105,** domestic hot water may be heated from reservoir **105** by use of a heat exchanger, and optionally may be stored in a separate tank **106.** Separate storage with independent temperature control may be advantageous because domestic water should be stored within a narrow temperature range for safety and utility reasons. The medium in reservoir **105** may undergo large temperature fluctuations during operation of system **100,** and may reach temperatures that would be unsafe for domestic hot water use.

A similar arrangement may be used for water used for space heating. Water from reservoir **105** may be circulated to a hydronic heating loop **107** that may include baseboard, subfloor, valence or other piping and fixtures that provide heat to spaces in the building primarily through convection, radiation, or both. Alternatively, the fluid circulated through hydronic heating loop **107** may derive its heat from reservoir **105** through a heat exchanger. Optionally, a separate storage tank **108** may be provided for the water or other fluid used for hydronic heating, enabling separate temperature control. In some embodiments, the fluid used for hydronic heating may be a fluid other than pure water, for example a water and antifreeze mix.

Optionally, backup heating may be provided to one or more of the heated reservoirs in the system, including any one, any combination, or all of reservoir **105** and any additional storage tanks such as tanks **106** and **107.** Backup heating may be in the form of a boiler or other kind of heater that bums fossil fuel, or may be another kind of heater. Backup heating may be required during extended periods without adequate sun to maintain a sufficient temperature of reservoir **105,** or during times when temporary guests increase the energy demands of building **109.**

If backup heating is supplied to reservoir **105,** then a single backup heater may be sufficient. Alternatively, separate backup heating units may be provided for domestic hot water tank **106** and space heating storage tank **108,** if they are present. In yet another attractive alternative, backup heating for domestic hot water may be an "on demand" type heater that heats water only as it is used, rather than maintaining a tank of hot water at a specified temperature. An on-demand heater may be placed at a central location and heat water for domestic hot water use throughout the building, or multiple on-demand heaters may be placed at the various points of use of hot water, such as one in each bathroom and kitchen.

In another aspect of system **100,** water or another fluid is circulated by a pump (not shown) through an environment-coupled piping loop such as deep earth-coupled piping loop **110.** Deep earth-coupled piping loop **110** cools this "cooling fluid" by virtue of its thermal contact with the earth. Heat is exhausted from the cooling fluid to the earth, thereby maintaining the cooling fluid at a relatively cold temperature. At sufficient depths, usually about five feet (1.6 m) or more below the surface, the earth maintains a relatively constant temperature, for example about 54-57 °F (12-14 °C) in many parts of the United States. Alternatively or additionally, other environment-coupled piping loops such as shallow earth-coupled piping loop **122** or air-coupled piping loop **123** may be used as described in more detail below. Optionally, a storage tank **111** for some of the cooling fluid is provided. The cooling fluid may also be used for multiple purposes. In one use, some of the cooling fluid is circulated as needed through a hydronic cooling loop **112** that may include baseboard, subfloor, valence or other piping and fixtures that remove heat from spaces in the building primarily through convection, radiation, or both. It is estimated that 1000 feet of tubing coiled in a trench 100 feet long can provide one ton (12,000 BTU/hr, or 3.516 kW) of cooling capacity. Vertical cooling wells can be used to save space, but at a slightly higher installation cost. Preferably, the pump circulating the cooling fluid operates only as needed to maintain a relatively cold temperature in the fluid supplied to hydronic cooling loop **112,** and for electricity generation as described below. Typically, fluid will be circulated through only one of hydronic cooling loop **112** and hydronic heating loop **107** at any one time.

Generation of electricity is provided by a thermoelectric generator **113.** A thermoelectric generator generates electrical power from a difference in temperature using the thermoelectric effect exhibited by many materials. A typical thermoelectric generator comprises many thermoelectric elements arranged in thermoelectric couples. Each thermoelectric element may be a conductive or semiconductive element, for example pieces of n-type and p-type semiconductor material. The elements are connected electrically in series and thermally in parallel in a thermoelectric module. The module produces a direct current (DC) voltage that is a function of the properties of the materials used, the temperature differential, the absolute temperature at which the generator is operated, the size of the module, and other factors. More information about thermoelectric generators is given below. A thermoelectric generator may have a life span of 200,000 hours, making it suitable for long-term use without expensive replacement.

In system **100,** the temperature differential between reservoir **105** and the cooling fluid circulating through an environment-coupled piping loop is exploited to generate electricity. Fluid drawn from or heated by reservoir **105** may be circulated to a "hot" side of thermoelectric generator **113,** while cooling fluid is circulated to a "cold" side of thermoelectric generator **113.** In some embodiments, for residential use, thermoelectric generator **113** produces about 1 kW when subjected to a temperature differential of 110 °F (61 °C). This amount of power is sufficient to supply most of the electrical needs of a conservatively-managed household. The system may be scaled up as needed by adding additional capacity to reservoir **105** and additional thermoelectric modules to thermoelectric generator **113.**

While deep earth-coupled piping loop **110** is one example of an environment-coupled piping loop that may be used to cool the cooling fluid, the system may be further optimized by the use of other kinds of environment-coupled loops as well. For example, a shallow earth-coupled loop **122** may be provided. Shallow earth-coupled piping loop **122** may be placed, for example, within about 1.5 feet (0.5 m) of the ground surface. During the winter, soil temperatures near the surface may be significantly colder than the relatively constant temperature maintained several feet below surface. In some places, the ground may even freeze to a depth of several inches during the winter. The temperature differential experienced by thermoelectric generator **113,** and therefore also the amount of power generated by thermoelectric generator **113,** may be increased if the cooling fluid is circulated through shallow earth-coupled piping loop **122** rather than deep earth-coupled piping loop **110** during times when the surface temperature is colder. Similarly, alternatively or additionally, an air-coupled piping loop **123** may be provided. During times of extreme cold weather, air-coupled piping loop **123** exposed to the atmosphere may experience temperatures even colder than shallow earth-coupled piping loop **122,** and may therefore cool the cooling fluid to an even colder temperature so that the amount of power generated by thermoelectric generator **113** may be even further increased by circulating the cooling fluid through air-coupled piping loop **123.**

When any of the environment-coupled piping loops is expected to experience below-freezing temperatures, the cooling fluid circulated through that loop is preferably not pure water, but may be water mixed with anti-freeze, or another kind of fluid. It is not necessary that all of the environment-coupled piping loops be present or carry the same cooling fluid, as long as the cooling fluids can efficiently remove heat from thermoelectric generator **113.** Typically, the cooling fluid would be circulated through only one environment-coupled piping loop at a time. In one scenario, a system controller selects which environment-coupled piping loop to utilize at any particular time based on the temperatures experienced by each of them.

Because a thermoelectric generator produces DC, system **144** may include as many appliances and other electrical devices as possible that can operate on DC power. For example, lighting **114** may be based on light emitting diodes (LEDs) for very efficient light production from DC power. Many other appliances are available that operate on DC power, and it is anticipated that the number of available DC-powered appliances will grow in the future. For those loads that can utilize DC power, system **100** preferably includes a DC power bus throughout building **109.**

In the interim, some loads may still best utilize alternating current (AC) power, for example refrigerator **115.** System **100** may therefore include one or more inverters **116,** which convert the DC output of thermoelectric generator **113** to AC power. In some embodiments, multiple small inverters may be used in place of a single large-capacity inverter, so that in the event of an inverter failure, a reduced-capacity system can still be operated until the failed inverter is repaired or replaced.

Backup may also be provided for the electrical portion of system **144,** in the form of a connection **117** to the mains grid, for example a public utility. Alternatively, a local gasoline-powered or other generator may be connected at connection **116** for emergency use or during times of increased electrical use, for example when hosting guests.

As is apparent from the above discussion, system **100** provides many useful advantages, including the use of energy stored in reservoir **105** for multiple purposes, including both heating and electrical generation. Because energy is stored in reservoir **145,** heating, cooling, and electrical generation can continue even at night or during inclement weather when little or no solar radiation is available.

Figure 1 shows also shows other optional features of system **140,** in accordance with other embodiments. Thermoelectric generator **113** may power a hydrogen generator **118** that generates hydrogen, for example from supply water by means of electrolysis or another process, when power is available from thermoelectric generator **113.** In one mode of operation, power may be diverted to the hydrogen generator overnight when electrical demands of building **109** are otherwise low. Hydrogen from hydrogen generator **118** could be supplied to a hydrogen powered vehicle **119,** or could be stored for other uses, for example to heat domestic hot water when backup heating is needed. Hydrogen generator **118** and associated storage would thus provide additional energy storage utilized during times when reservoir **105** is at its thermal capacity and surplus power is available from thermoelectric generator **113.**

Because thermoelectric generator **113** has a finite power output capability, it may be helpful to manage the power demand of building **109.** In some embodiments, a load controller **120** may be provided that manages the operation of certain appliances. Load controller **120,** may be, for example, a computerized device that monitors the operation of various appliances and other loads, and controls the availability of power to them. The effect may be time-shifting of certain loads in deference to other loads so that power is made available where needed, but the overall operation of the appliances is still satisfactory. In one simple example of the operation of load controller **120,** refrigerator **115** maybe prevented from operating when microwave oven **121** is in operation. A microwave oven is an appliance that the user typically wants to use immediately for a short time. A refrigerator operates intermittently, and persons in the household often are not even aware of whether the refrigerator is running. A short delay in the operation of a refrigerator has negligible effect on its performance. Delaying the operation of the refrigerator **115** until microwave **121** is finished prevents both from contributing to the electrical demand at the same time, with little or no perceived effect on the operation of either appliance. Potentially, this arrangement reduces the peak electrical demand of building **109.** Many other appliance timing, delay, or interlock strategies may be envisioned. For example, the operation of a clothes dryer may be prevented while an electric range is in operation, or the intensity of lighting may be reduced to free up electrical capacity for the operation of a hair dryer. Many other examples are possible. In other embodiments, certain appliances may be constrained to operate only during certain times of the day. For example, a clothes dryer may be allowed to operate only between 10:00AM and 3:00PM, when maximum solar radiation is typically available.

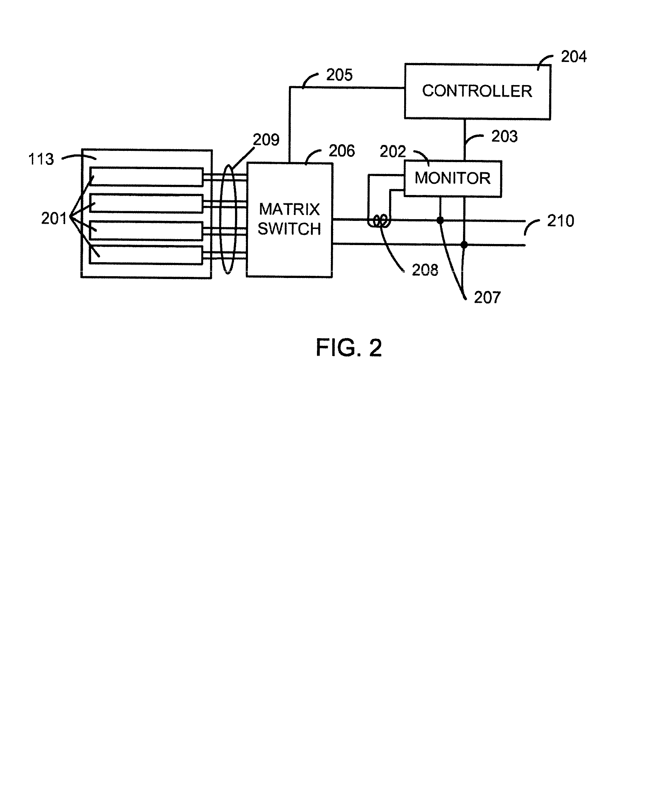

**Figure 2** shows a portion of system **100** in greater detail, in accordance with another embodiment. As thermal energy is drawn from reservoir **105,** whether for heating or electricity generation, the temperature differential across thermoelectric generator **113** decreases, and consequently the voltage produced by thermoelectric generator **113** also decreases. Certain loads may have specific voltage ranges in which they must operate. For example, inverter **118** may require that its input voltage be within a certain range, or DC appliances may operate most effectively when supplied with power within a specified voltage range, e.g. near 36 of 48 volts.. In the embodiment of Figure 2, thermoelectric generator **113** comprises multiple banks **201** of thermoelectric elements. Each bank produces a portion of the electrical power available from thermoelectric generator **113,** and outputs its power on one of sets of leads **209.** A matrix switch **206** dynamically configures the interconnections of the banks to maintain certain power characteristics at main output leads **210.** For example, when the full temperature differential is available, matrix switch may configure the banks in parallel, but when the temperature differential is reduced such that each bank produces only a fraction of the voltage it produces at full power, matrix switch **206** may connect the banks in series so that the output voltage is maintained within the required levels. Matrix switch **206** may also interconnect the banks in various series and parallel combinations as needed.

A monitor **202** senses the character of the power being produced at main output leads **210,** and sends a signal **203** to a controller **204,** which then signals **205** matrix switch **206** to change its interconnection. Monitor **202** may measure the voltage produced at leads **210** using sensing connections **207,** may measure the current being supplied using a current probe **208,** or may measure some other characteristic upon which to make a decision about the interconnection of the banks.

In this way, nearly all of the energy stored in reservoir **105** may be extracted for electricity generation. (Although the amount of available power may decline as the temperature of reservoir **105** declines.) By comparison, batteries may be restricted to supplying only 20% of their stored energy. More detail about the operation of matrix switch **206** is given below.

### Automatic Configuration of Thermoelectric Generator

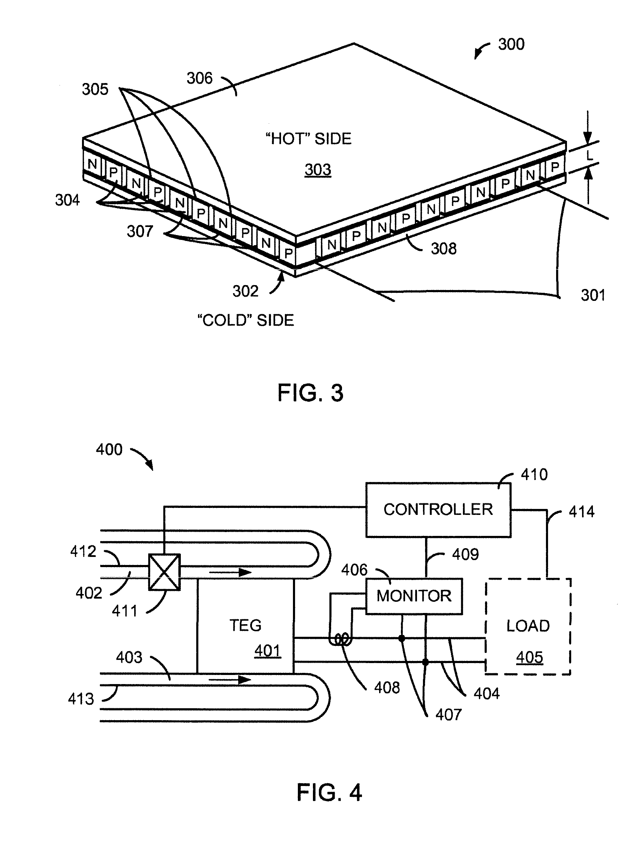

A thermoelectric module is a device that exploits the thermoelectric effect exhibited by many materials. **Figure 3** shows a schematic diagram of the operation of a thermoelectric module **300.** A thermoelectric module such as module **300** has the property that when current is passed through the module, for example at terminals **301,** one side **302** of the module is cooled and the other side **303** is heated. Thermoelectric modules are used in this way in certain consumer devices such as water coolers and the like.

The thermoelectric effect is reversible, such that when the two sides of a thermoelectric module are held at different temperatures, the module can generate electric power. For example, in Figure 3, rather than driving a current through terminals **301** to heat and cool module sides **302** and **303,** the module sides **302** and **303** may be held in a temperature differential, and a voltage will be produced across terminals **301.** When used to generate power, a thermoelectric module may be called a thermoelectric generator (TEG). The voltage produced and the amount of power available from the module depend on the temperature differential between the two sides **302** and **303,** the materials used to construct the module, the absolute temperature at which the module is operated, the size of the module, and other factors.

This variability of available power makes it difficult to use thermoelectric generation to exploit temperature differentials or gradients that are variable, especially to supply power to a load that has specific requirements for the character of the power it receives.

Thermoelectric module **300** is but one example of a thermoelectric device usable by embodiments of the invention. Module **300** is made up of a number of thermoelectric elements **304**, each of which is a length of conductive or semiconductive material with favorable thermoelectric properties. For example, the elements may be pieces of n-type and p-type semiconductor material, labeled "N" and "P" in Figure 3. The thermoelectric elements **304** are arranged in thermoelectric couples, each thermoelectric couple including one "N" element and one "P" element. The ends of the elements in each thermoelectric couple are electrically connected at hot side **303** of module **300** by one of conductors **305**, and are further thermally connected to a heat source through an optional header **306**. The various thermoelectric couples are connected in series at cold side **302** of module **300**, by conductors **307**, and are also thermally connected to a "cold" source or header **308** at the cold side **303** of module **300**. Each thermoelectric couple generates a relatively small voltage, and the voltage appearing at leads **301** is the accumulated voltage of the series-connected thermoelectric couples. While many thermoelectric modules are made using n-type and p-type semiconductor materials for the thermoelectric elements **304**, it will be understood that the invention is not so limited. Many other kinds of materials known and yet to be developed exhibit the thermoelectric effect, and may be used in embodiments. Similarly, other arrangements of the elements may be envisioned.

Preferably, thermoelectric modules used in embodiments of the invention are optimized for power generation. Research has shown that the total power available is maximized when the length "L" of the thermoelectric elements is quite short - for example about 0.5 millimeters. However, the conversion efficiency of a thermoelectric module (the fraction of available thermal energy actually converted to electrical energy) increases with increasing length L. For example, a thermoelectric element with a length of 5.0 millimeters may be several times more efficient than one with a length of 0.5 millimeters. The optimum length for a particular application (providing the minimum cost per expected unit of electrical energy) will be a function of the cost of the thermoelectric modules and associated hardware, the cost of the thermal energy supplied to the thermoelectric generator, and the expected life of the thermoelectric generator. A more complete discussion of the factors involved in optimizing the performance of a thermoelectric module may be found in D.M. Rowe and Gao Min, Evaluation of thermoelectric modules for power generation, Journal of Power Sources 73 (1998) 193-198.

**Figure 4** illustrates a system **400** in accordance with an embodiment of the invention. A thermoelectric generator (TEG) **401** generates electric power when it is subjected to a temperature differential. In Figure 4, the temperature differential is provided by a heated fluid **402** and a relatively cold fluid **403** piped to opposite sides of TEG **401.** For the purposes of this disclosure, a thermoelectric generator is a device that produces electric power when subjected to a temperature differential. A thermoelectric generator may, but need not, include many thermoelectric modules such as thermoelectric module **300,** which may in turn include many thermoelectric elements arranged in thermoelectric couples.

It is to be understood that a temperature differential may be provided by any of many, many different media and apparatus. For example, heated fluid **402** may be produced specifically for the purpose of generating electricity, for example by heating water using conventional fossil fuels, solar energy, or by some other means. Alternatively, heated fluid **402** may be the by-product of an industrial process, waste water from an establishment such as a car wash or laundry, naturally occurring hot spring water, or another kind of fluid.

The "hot" side of a temperature differential may be provided by another medium besides a fluid, for example, air exhausted from a building air conditioning system, exhaust gasses from an engine, the surface of any component such as a vehicle exhaust pipe, oven exterior, blast furnace environment, or other suitable heat source.

Similarly, relatively cold fluid **403** may be obtained specifically for the purpose of power generation, or may be the by-product of some other process. For example, cold fluid **203** may be water that is circulated through an underground pipe to cool the water to the temperature of the ground - typically about 54-57 °F (12-14 °C) in many parts of the United States. Or fluid **403** may be any naturally-occurring relatively cold fluid, for example water diverted from a river or stream. The "cold" side of a temperature differential may be provided by media and materials other than fluids, for example ambient air, a metallic object, or some other suitable "cold" source.

Nearly any temperature differential may be exploited for power generation, and the terms "hot", "heated", "cold", and the like are to be understood to be relative terms. For example, both the "hot" and "cold" sides of a temperature differential may be perceived as hot to human senses, but the differential may still be exploited by a TEG. Similarly, both the "hot" and "cold" sides of a temperature differential may be considered cold by human senses.

Returning to Figure 4, TEG **401** produces electric power, which is output on leads **404** and supplied, directly or indirectly to a load **405.** Load **405** is shown in dashed lines in Figure 4 to emphasize that it is not considered to be part of the invention, unless specifically claimed. Load **405** may have specific requirements for the power it receives in order to operate properly. For example, load **405** may include an inverter configured to supply alternating current to an area, and the inverter may operate properly only when supplied with a DC voltage between 36 and 48 volts. Or the load may comprise a microprocessor-based system that requires a minimum amount of power for error-free operation.

A monitor **406** senses at least one aspect of the power generated by TEG **401.** For example, probe leads **407** may tap into leads **404** to enable monitor **406** to measure the voltage being output by TEG **401.** A current probe **408** may enable monitor **406** to measure the current being output by TEG **401.** Other measurements are possible, and other aspects of the power maybe measured or derived. For example, monitor **406** may multiply the output voltage and current to measure the amount of power being provided by TEG **401.**

Monitor **406** provides at least one signal **409** that characterizes the power being generated by TEG **401.** While the signal is represented in Figure 4 as a line, it is to be understood that the signal may be an analog signal, a digital signal, a numerical value carried in either analog or digital form, or another kind of signal.

Signal **409** is supplied to a controller **410.** Controller **410** is preferably a microprocessor-based device including a processor, memory, and input/output capabilities, but may be another kind of controller as well. Controller **410** is supplied with a description of the power requirements of load **405.** For example, an indication of the requirements may be stored in a memory comprised in controller **410.** Controller **410** preferably includes program instructions stored in memory or another kind of machine readable medium. The program instructions, when executed by the processor, enable the controller to carry out its functions. Controller **410** is configured to receive signal **409** and configure at least one configurable component based on signal **409** in accordance with the requirements of load **405.** For example, controller **410** may recognize the voltage being produced by TEG **401** is above or below the optimum for load **405,** and may take action to adjust the voltage by configuring another component in the system.

One example of a configurable component is valve **411** shown in Figure 4. In this example, valve **411** is placed in a flow line **412** carrying heated fluid **402** to the "hot" side of TEG **401.** Valve **411** is controllable by controller **410.**

In one example scenario, controller **410** may recognize that the voltage being supplied by TEG **401** is above or nearly above the maximum voltage that load **405** can accept, and may instruct valve to close, thereby reducing the flow of heated fluid to TEG **401.** Many other control scenarios are possible. For example, controller **410** may recognize that the voltage being produced by TEG **401** is below or nearly below the minimum voltage required by load **405,** and may cause valve **411** to open, thereby increasing the flow of heated fluid to TEG **401.** Similarly, a valve could be inserted into flow line **413** carrying relatively cold fluid to the "cold" side of TEG **401,** and controller **410** may regulate the flow of the relatively cold fluid in accordance with signal **409** and the requirements of load **405.** In another scenario, controller **410** may recognize that load **405** is shut off and not drawing any current, and controller **410** may then control valve **411** to completely shut off the flow of heated fluid so as to not deplete a reservoir of heated fluid.

In some embodiments, controller **410** produces a second, output signal **414** that indicates a status of the power being generated by TEG **401.** While second signal **414** is shown in Figure 4 as being directed to load **405,** second signal **414** may be directed to any other suitable location. Second signal **414** may indicate, for example, the amount of power being generated by TEG **401,** or may be an indication that the system is no longer able to produce power in accordance with the requirements of load **405.** Second signal **414** may be an analog signal, a digital signal, a wireless signal, may be transmitted over a wire or cable, may be presented on a display, or may be communicated in any other suitable manner.

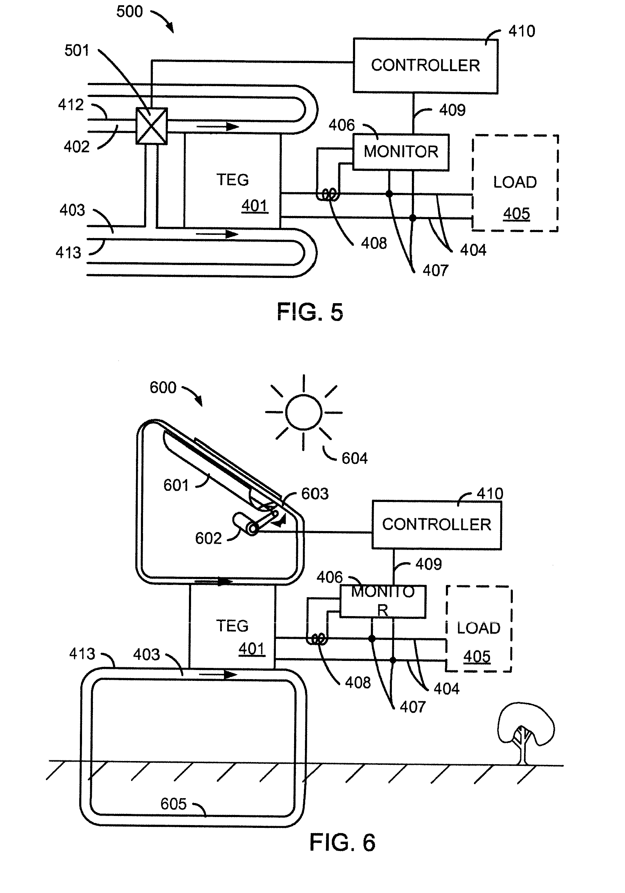

In another scenario, controller **410** may regulate the temperature of either heated fluid **402,** or relatively cold fluid **403,** or both. **Figure 5** illustrates a system **500,** an embodiment in which controller **410** regulates the temperature of heated fluid **402** using a mixing valve **501** that variably mixes cold fluid into heated fluid **402** to control the temperature of heated fluid **402.** For example, if controller **410** recognizes that the voltage being output by TEG **401** exceeds or nearly exceeds the voltage requirement of load **405,** controller **410** may adjust valve **501** to cause the temperature of heated fluid **402** to be reduced, in order to reduce the temperature differential experienced by TEG **401,** thereby reducing the voltage produced by TEG **401.** Similarly, if controller **410** recognizes that the voltage being produced by TEG **401** is below or nearly below the minimum required by load **405,** controller **410** may reduce the amount of cold fluid mixed with heated fluid **402** by valve **501** or may stop all mixing in order to increase the temperature differential experienced by TEG **401,** thereby increasing the voltage produced by TEG **401.** One of skill in the art will recognize that warm fluid could also be mixed into relatively cold fluid **403,** and adjusted to adjust the voltage produced by TEG **401.**

Many other kinds of configurable components are possible. For example, if air is used to provide a temperature differential to TEG **401,** a configurable component may include a fan that cools the "cold" side of TEG **401,** and the fan may be turned on or off, or adjusted in speed by controller **410.** A configurable component may adjust the media at the "hot" side af TEG **410,** or the "cold" side af TEG **401,** or both.

**Figure 6** illustrates a system **600** including another kind of configurable component. In the system of Figure 6, heated fluid **402** is supplied from a concentrating solar collector **601,** which is rotated by motor **602.** For example, solar collector **601** may have a parabolic shape that focuses incoming solar radiation on tube **603** when collector **601** is properly aimed at the sun **604.** Fluid from tube **603** may be circulated to TEG **401,** providing the "hot" side of the temperature differential exploited by TEG **401** to generate electric power. In this embodiment, the configurable component adjusted by controller **410** may be the rotational angle of collector **601,** as controlled by motor **602.** For example, if controller **410** recognizes that the voltage being produced by TEG **401** is above or nearly above the maximum voltage acceptable to load **405,** controller **410** may send a signal to motor **602** to defocus or adjust the aiming of collector **601** so that collector **601** no longer points directly at the sun **604.** In that case, less heat will be supplied to heated fluid **402,** reducing the temperature differential experienced by TEG **401,** and reducing the voltage produced by TEG **401.** Conversely, when controller **410** recognizes that the voltage produced by TEG **401** is below or nearly below the minimum required by load **405,** and that collector **601** is not aimed at the sun **604,** controller **410** may control motor **602** to once again aim collector **610** at the sun, increasing the amount of heat supplied to fluid **402,** increasing the temperature differential experienced by TEG **401,** and increasing the voltage produced by TEG **401,** The position of the sun **604** may be tracked by sensors not shown in Figure 6 for simplicity of illustration. One of skill in the art will recognize that motor **602** may be any suitable kind of motor, including a stepper motor, a DC servo motor, and AC servo motor, or other kind of motor. Control electronics for driving motor **602** are omitted from Figure 6 for clarity.

Figure 6 also shows one particular embodiment for providing relatively cold fluid **603** to TEG **401**. In Figure 6, tube **613** connects with an underground loop **605.** As is well known, the temperature of the ground at sufficiently deep levels remains relatively constant throughout the year. In some parts of the United States, for example, the underground temperature may be about 54-57 °F (12-14 °C). Water may be circulated by a pump (not shown) through loop **605** after absorbing heat from the "cold" side of TEG **401,** thereby cooling the water by transferring its absorbed heat to the ground. This way, the "cold" side of TEG may be maintained at a sufficiently cold temperature at little cost. While loop **605** is shown as a single straight section in Figure 6, many other configurations are possible. For example, loop **605** may be in a substantially vertical orientation in a relatively deep well, or loop **605** may include a series of coils placed in a trench.

One of skill in the art will recognize that other kinds of adjustments may be made to a system that uses solar energy to heat the heated fluid provided to TEG **401.** For example, rather than a concentrating collector, a flat panel solar collector could be used, and controller **410** may control a shade that can be moved to block solar radiation from reaching the flat panel collector, or to allow solar radiation to reach the collector.

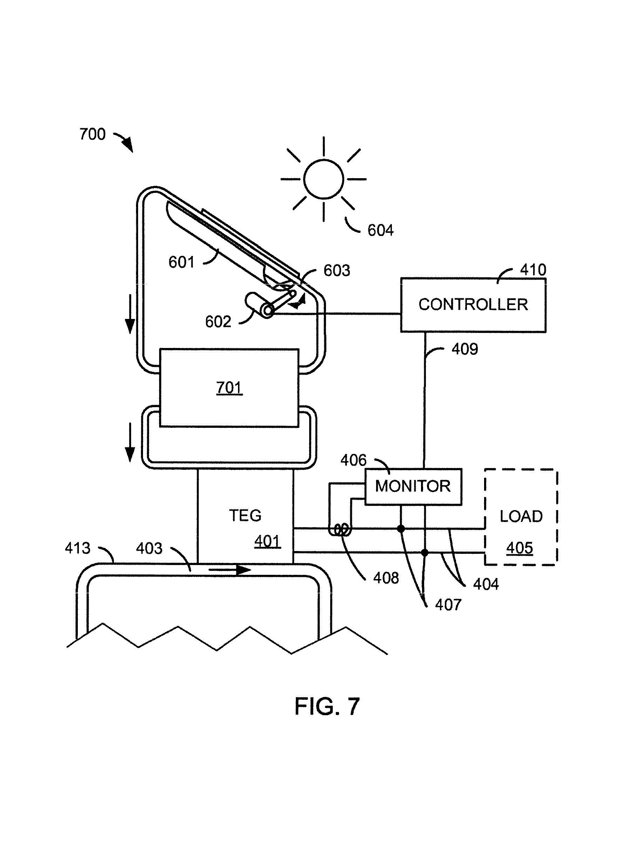

**Figure 7** illustrates another embodiment that uses solar energy for heating a fluid supplied to TEG **401.** This embodiment is similar to the embodiment shown in Figure 6, but includes a storage tank **701,** for example for holding water. Fluid circulating through collector **601** heats the water or other fluid in tank **701,** which is then circulated to TEG **401** to provide the "hot" side of the temperature differential for TEG **401.** The fluids used by collector **601** and TEG **401** may be but need not be the same. For example, a high-temperature-tolerant oil may be circulated through collector **601,** imparting its heat to water in tank **701** using a heat exchanger. Similarly, tank **701** may use another fluid besides water. Many combinations are possible.

The embodiment of Figure 7 has the valuable advantage for storing heat that can be used for later generation of electric power by TEG **401.** For example, water in tank **701** may be heated during the day, and the heated water may be circulated to TEG to generate electric power at night. Preferably, tank **701** is insulated, so that it will retain heat for extended periods.

While the control embodiments described above have included configurable components that adjust the temperature differential or amount of thermal energy available to a TEG, other kinds of configurable components may be used. In place of or in addition to adjustments made to the temperature differential or thermal energy supplied to the TEG, the output of the TEG may also be configured using electrical techniques and components. Control on the electrical side of the system may be especially advantageous in conjunction with a system that includes hot liquid storage, such as system **700.**

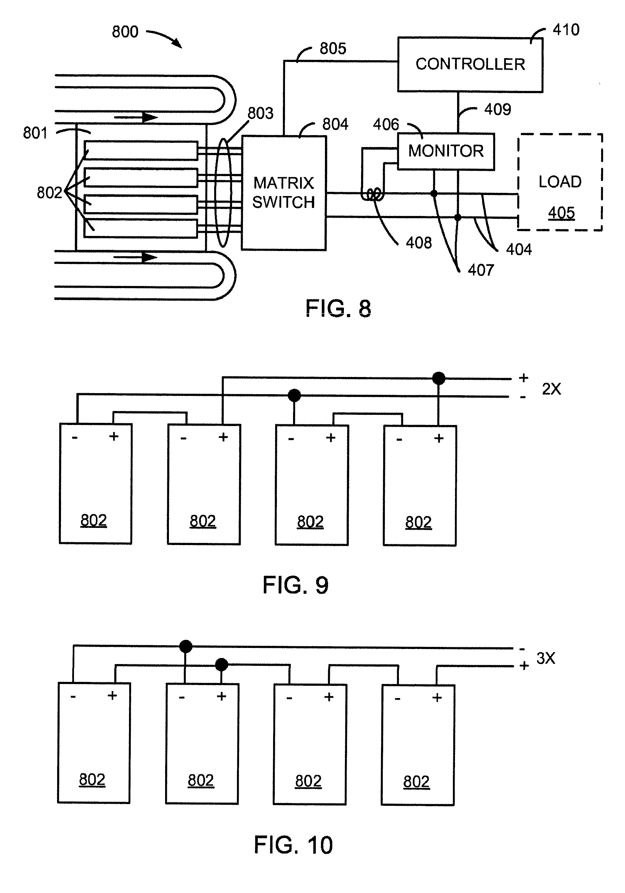

**Figure 8** illustrates another embodiment **800,** in which the output of a TEG **801** is adjusted electrically. While TEG **401** shown in Figure 4 was represented as a monolithic block, TEG **801** shows additional internal structure. TEG **801** is made up of multiple banks **802.** Each bank 802 includes at least one thermoelectric module, and generates at least a portion of the power generated by TEG **801.** While banks **802** are shown as stacked together in Figure 8, this is not a requirement. Preferably, each bank **802,** and even each module within each bank **802,** is exposed to the full temperature differential experienced by TEG **801.** Internal piping or other routing of fluids is omitted from Figure 8 for clarity.

The leads **803** from modules **802** are individually routed to a matrix switch **804,** which will be described in more detail below. While matrix switch **804** is shown in Figure 8 as separate from TEG **801,** the two components may be integrated into a single unit. Matrix switch **804** is controllable by controller **410,** and can dynamically reconfigure the interconnections of modules **804** to adjust the character of the power being delivered by TEG **801.** It is to be understood that control signal **805** shown passing from controller **401** to matrix switch **804** may in fact comprise several separate signals, including addressing lines and command lines. Alternatively, control signal **805** maybe a message transmitted to matrix switch **804,** which may have its own internal intelligence for interpreting the control signal and carrying out the necessary operations.

For example, each bank **802** may nominally produce power at 24 volts when subjected to a temperature differential of 50 °C, and load **405** may require that power be supplied at a voltage between 30 and 50 volts. When the temperature differential is at or slightly below 50 degrees, an efficient interconnection of the banks would be to place pairs of banks in series, and then place the series sets in parallel, so that the voltage output from matrix switch **804** is approximately two times the voltage produced by an individual bank, or nominally 48 volts. This arrangement is shown schematically in **Figure 9****.** Alternatively, pairs of banks could be placed in parallel, and the sets placed in series, also resulting in a nominal 48 volts.

If the temperature differential declines, for example if the system operates in this configuration for an extended period when tank **701** is not being reheated, the voltage produced by each bank will decline from the nominal 24 volts, and the voltage supplied to load **405** will decline. When the voltage produced by each bank reaches 16 volts, the voltage supplied to the load will be only 32 volts (two times 16). If the voltage produced by each bank drops below 15 volts, the voltage to the load will drop below 30 volts - below the minimum requirement for load **405.**

At this point, it would be advantageous to reconfigure the interconnections of the banks, for example to place two banks in parallel, and place that pair in series with the two other banks, so that the resulting output voltage is nominally three times that produced by each individual module. This configuration is shown schematically in **Figure 10****.** This configuration brings the output voltage back within a usable range. The total amount of power may decline as an unavoidable consequence of the decline in temperature differential.

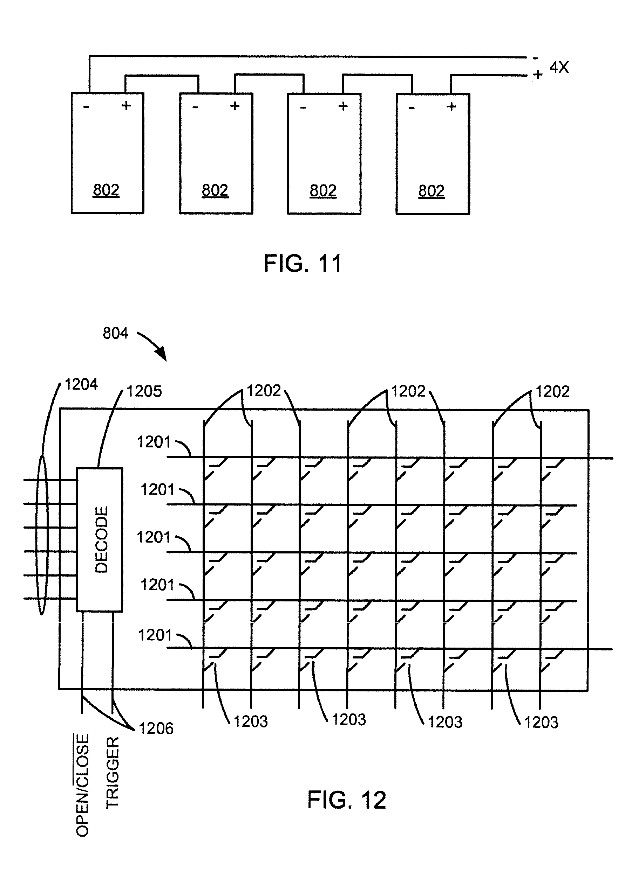

If the temperature differential drops further, for example to the point that each bank produces less than 10 volts, then even three times the voltage of an individual bank will be out of the range required by load **405.** At this point, it would be advantageous to place all four banks in series, so that the output voltage is four times the voltage of an individual bank, or more precisely, the sum of the voltages produced by the four individual banks. For ease of explanation, it is assumed in most of this discussion that the banks perform identically to each other. This assumption is sufficiently accurate to explain the nominal operation of the system, but in practice, there may be variations in performance among the banks, so that the output voltage of the system may not be an exact integer multiple of the voltage of any one bank. It is to be understood that the claims encompass such real-world operation. The arrangement of all four banks in series is shown schematically in **Figure 11****.**

By proper configuration of the interconnection of the banks, it is possible to achieve an output voltage that is nominally any integer multiple of the voltage produced by an individual bank, up to the number of banks. With four banks as shown in Figure 8, the voltage supplied to load **405** may be 1, 2, 3, or **4** times the voltage produced by an individual bank. If 12 banks are used, then the voltage supplied to the load could be nominally 1,2,3, ..... 11, or 12 times the voltage produced by an individual bank. Using a larger number of banks allows finer control of the total output voltage, and enables control within a narrower range.

The reconfiguration of the bank interconnections may be accomplished using matrix switch **804,** under the control of controller **410.** **Figure 12** shows a more detailed schematic diagram of matrix switch **804.** In its general form, matrix switch **804** comprises two sets of conductors that may form a grid pattern. For ease of reference, these will be referred to as horizontal conductors **1201** and vertical conductors **1202,** however these terms refer only to the representations in the Figures, and do not limit the invention to conductors in strictly horizontal and vertical orientations. The conductors need not form a uniform grid pattern. This kind of switch is also sometimes referred to as a "crossbar switch". Matrix switch **804** also comprises addressable switches **1203** (only a few of which are labeled) that can make or break connections between crossing pairs of conductors **1201, 1202.** If every intersection in the matrix switch is provided with an addressable switch, then any horizontal conductor **1201** can be connected to any or all of vertical conductors **1202,** and vice versa. The addressable switches may be any kind of suitable switch or relay, including electromechanical relays, solid state devices, or other kinds of switches. The addressable switches need not be all the same.

Addressable switches **1203** are operated using address lines **1204** and control lines **1206** from controller **410.** The details of decoding logic **1205** and the component interconnections are not shown in Figure 12, as one of skill in the art will recognize that many different arrangements are suitable, so long as controller **410** can close or open addressable switches **1203** to reconfigure the connections in matrix switch **804.** Addressable switches **1203** may be individually addressable, so that controller **410** can change the state of any one switch without affecting the others, or addressable switches **1203** may be addressable in groups, such as in pairs or other combinations. In some embodiments, not all intersections between horizontal and vertical conductors may have associated addressable switches. In this example, matrix switch **804** has two vertical conductors **1202** for each bank, and five horizontal conductors **1201,** which are sufficient to make the necessary connections for four banks **802.** Six address lines **1204** enable individual selection of any one of the 40 switches **1203.** Control lines **1206** provide an indication of whether the selected switch is to be opened or closed, and a strobe or trigger signal to cause the selected operation to occur. Controller **410** may be configured to perform the switch configurations in an order compatible with the characteristics of the banks **802,** and the load requirements. For example, controller **410** may avoid shorting the terminals of any bank **802,** and may perform switching operations in a "make before break" or "break before make" order, to avoid interruptions in the supply of power to load **405,** to protect banks **802** from damage, or for other reasons. Banks **802** may be characterized before assembly of the system, and controller **410** may be configured to preferably select banks with similar characteristics for parallel connections.

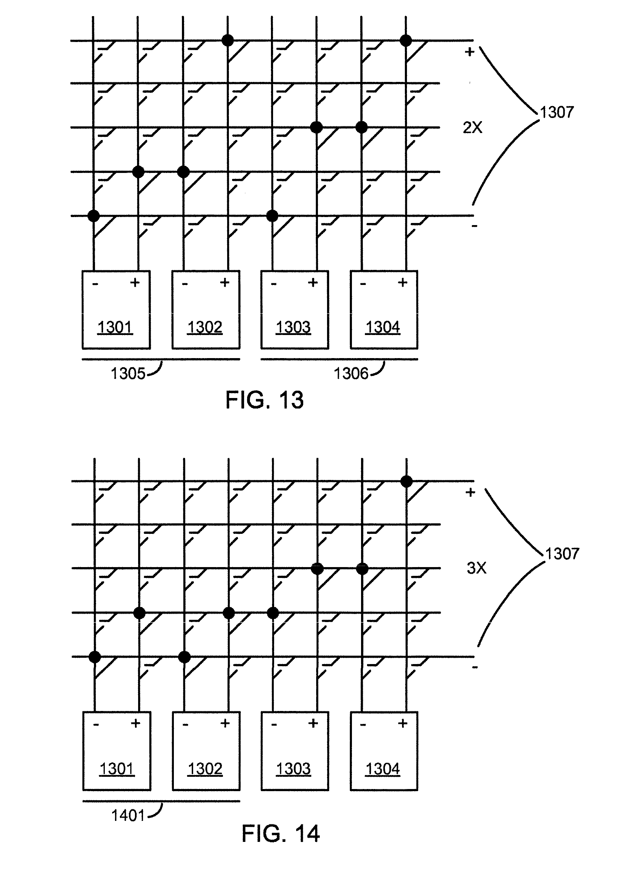

**Figure 13** shows matrix switch **804** configured to place banks **802** in the arrangement shown schematically in Figure 9. (The decoding logic of switch **804** is omitted for clarity.) That is, banks **1301** and **1302** are connected in series to form a set **1305,** banks **1303** and **1304** are connected in series to form a second set **1306,** and sets **1305** and **1306** are connected in parallel so that the output voltage across terminals **1307** is two times the voltage produced by a single bank.

**Figure 14** shows matrix switch **804** configured to place banks **802** in the arrangement shown schematically in Figure 10. That is, banks **1301** and **1302** are connected in parallel to form a set **1401,** which is then connected in series with banks **1303** and **1304** so that the output voltage across terminals **1307** is nominally three times the voltage produced by a single bank. In another possible configuration, any three of the banks could be connected in series, and the fourth bank left disconnected, so that the output voltage across terminals **1307** is nominally three times the voltage produced by a single bank.

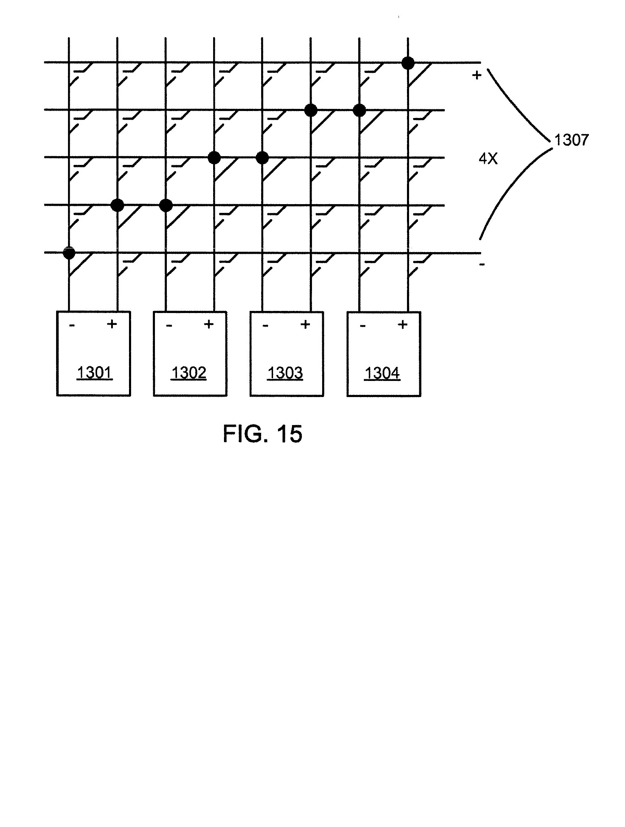

**Figure 15** shows matrix switch **804** configured to place banks **1301, 1302, 1303,** and **1304** all in series, so that the output voltage across terminals **1307** is nominally the sum of the voltages produced by the four banks, or four times the voltage produced by an individual bank.

In this way, the interconnections of the banks can be dynamically reconfigured to adjust the output voltage of TEG **801** to meet a requirement of load **405.** Preferably, the reconfiguration is performed in a sequence that avoids possible damage to banks **802.** For example, certain connections may be broken before others are made, such as to avoid connecting both terminals of a single bank together at any time. One of skill in the art will recognize that much larger matrix switches may be constructed, that can reconfigure much larger numbers of banks than the four shown in these examples. In this way, very large variations in the generating capacity of individual banks may be accommodated, while producing output power in accordance with the requirements of a load.

While matrix switch **804** is depicted for ease of explanation and conceptualization as being laid out in a rectangular matrix, and having a switch **1203** for every intersection between any horizontal conductor **1201** and vertical conductor 1202 (a total of 40 switches **1203),** these are not requirements. In the example configurations shown in Figures 13-15, only 12 of the switches **1203** ever change state. Of the other 28 switches depicted, 25 are never closed and could be omitted, and three remain closed and could be replaced with permanent electrical connections. One of skill in the art will recognize that it is desirable to construct a system with the fewest components possible in order to minimize the cost of the system. It is to be also understood that matrix switch **804** need not be implemented as a single integrated device and need not physically resemble a matrix, but may comprise logic and switch components that are located together or separately in any suitable locations in the system.

The capability to reconfigure the interconnections between modules may be especially useful in a system with thermal storage, such as system **700** shown in Figure 7. During extended periods without sun, the temperature of the fluid in tank **701** may decline until the temperature differential experienced by the TEG is only a few degrees. By reconfiguring the interconnection of modules in the TEG, usable power (in a declining amount) may be extracted over a very wide range of temperatures in tank **701,** and nearly all of the stored thermal energy may be utilized. This is in contrast to electrical energy stored in batteries. While a battery may store considerable energy, some kinds of batteries cannot be fully discharged without compromising the life of the batteries, and therefore not all of their stored energy may be utilized reliably.

In other embodiments, one or more of banks **802** may be made up of multiple thermoelectric modules (TEMs). For example, each of banks **802** may comprise 12 TEMs, each nominally producing 2 volts. When all 12 TEMs are connected in series, a bank then produces 24 nominal volts. Each bank may further comprise a module-level matrix switch that enables reconfiguration of the interconnections of the modules within a bank. In this case, matrix switch **804** may be referred to as a "bank-level" matrix switch, as it reconfigures the interconnections of the banks with each other. In this example, with 12 modules in a bank, a bank may be configured to produce any multiple of the voltage produced by a module, up to 12 times the module voltage.

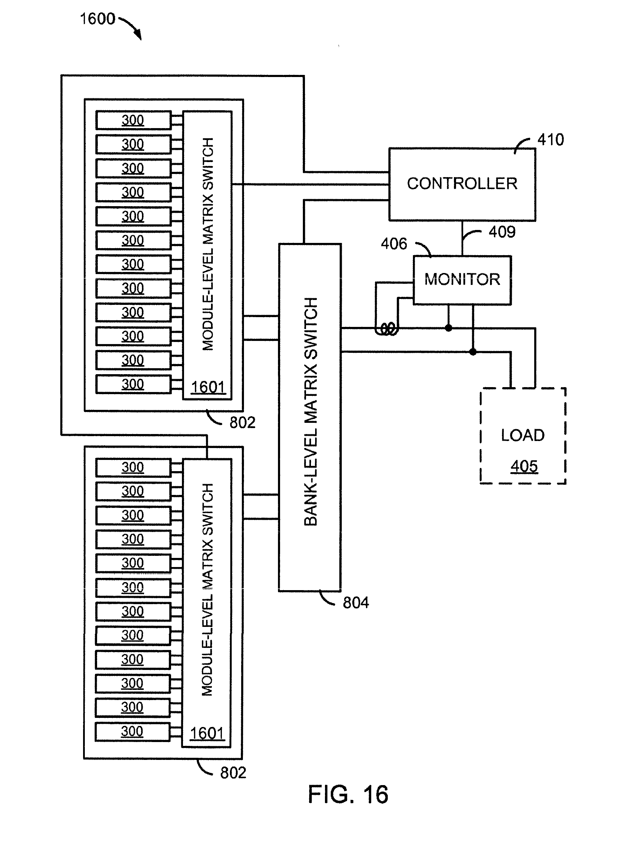

**Figure 16** illustrates a system **1600** wherein each of two banks **802** includes 12 TEMs **300.** Each bank includes a module-level matrix switch **1601,** which, under the control of controller **410,** reconfigures the interconnections of the TEMs **300** within its respective bank. Bank-level matrix switch **804** can reconfigure the interconnections of the banks **802.** Module-level matrix switch **1601** may be constructed similarly to bank-level matrix switch **804,** as is illustrated in Figure 12. As before, monitor **406** may measure one or more characteristics of the power being generated by the system, and may provide a signal **409** to controller **410** characterizing the power being generated. Based on the power characteristics and the requirements of load **405,** controller **410** may reconfigure the interconnections of the TEMs **300** within either or both banks **802,** or may reconfigure the interconnections of banks **802,** or may reconfigure connections of modules **300** and banks **802,** in any combination. In an alternative embodiment, the system may monitor the character of power being generated by each bank individually, in addition to or instead of monitoring the power being delivered to load **405,** and controller **410** may incorporate these different or additional measurements into its decision to reconfigure connections of TEMs **300,** banks **802,** or both.

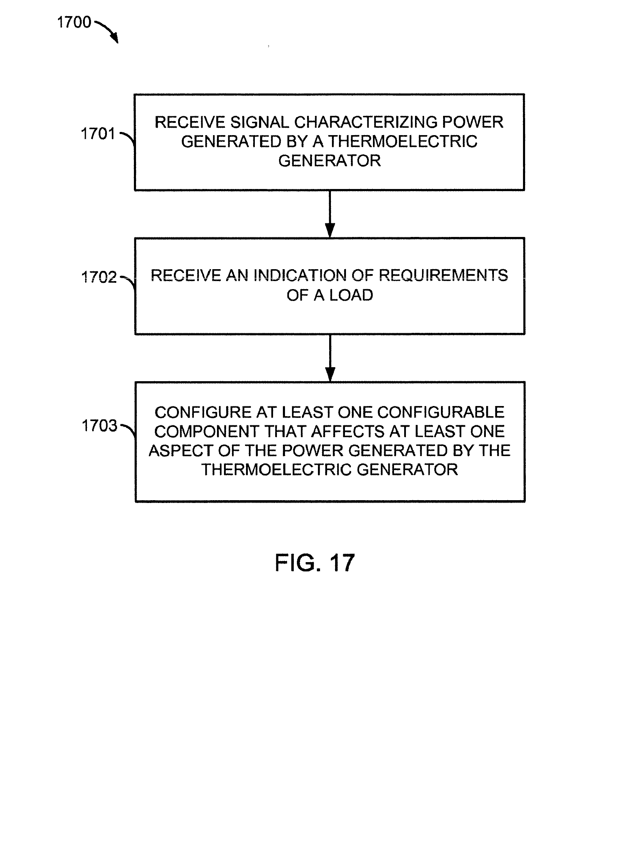

**Figure 17** illustrates a flowchart **1700** of a method in accordance with an embodiment of the invention. In step **1701,** a signal is received characterizing the power generated by a thermoelectric generator. In step **1702,** an indication is received of the requirements of a load. In step **1703,** at least one configurable component is configured, the configurable component affecting at least one aspect of the power generated by the thermoelectric generator.

### Thermoelectric Generator Embodiments

A typical commercially available thermoelectric module about 34 X 31 millimeters may produce about 1.5 watts of power at about 2.8 volts when subjected to a temperature differential of about 100 °C. While this amount of power is sufficient for certain small loads, it is small in comparison with the power requirements of a typical home. For practical power generation, it may be necessary to combine the outputs of a number of thermoelectric modules. Preferably, the modules can share the same hot and cold sources, and are electrically interconnected such that their combined power output is available for use.

Preferably, thermoelectric modules used in embodiments of the invention are optimized for power generation, as described above.

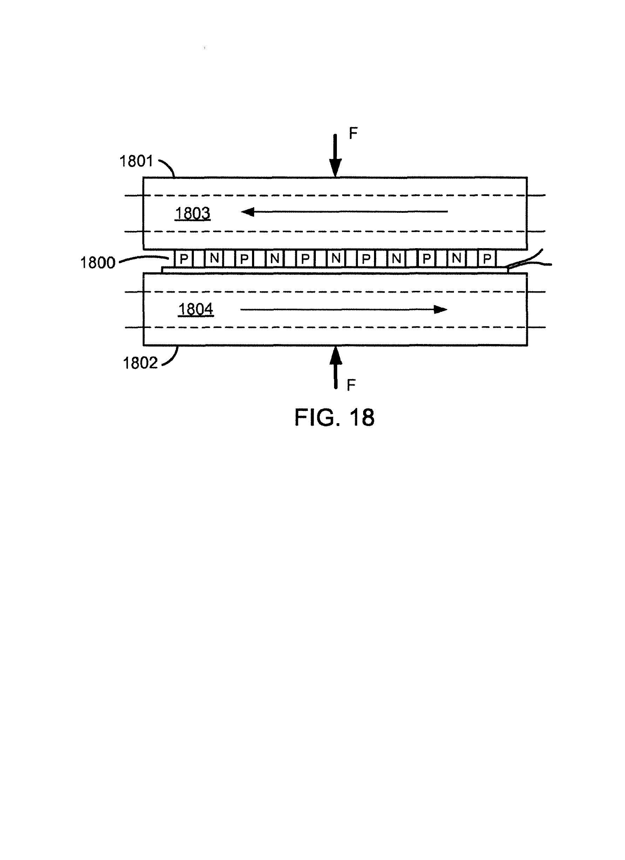

For maximum power output, it is advantageous to supply heat to the hot side of each thermoelectric module as efficiently as possible, and to remove heat from the cold side as efficiently as possible. **Figure 18** shows one example arrangement for a single thermoelectric module **1800.** In Figure 18, thermoelectric module **1800** is sandwiched between a heat source **1801** and a heat sink **1802.** For example, heat source **1801** may be a thermally conductive block through which a relatively hot fluid **1803** is circulated, and heat sink **1802** may be a conductive block through which a relatively cold fluid **1804** is circulated. Heat source **201** and heat sink **202** may be aluminum blocks through which relatively hot and cold water are circulated respectively. One of skill in the art will recognize that the terms "hot", "cold", "heated", and "cooled" are used in a relative sense. Hot fluid **1803** may not appear hot to normal human senses, and cold fluid **1804** may not appear cold. "Hot" and "cold" mean that the hot fluid is at a higher temperature than the cold fluid, and not that a person would necessarily perceive the fluids as "hot" or "cold." Similarly, a heat source and a heat sink may be provided by a structure other than a simple block. For the purposes of this disclosure, an element that supplies heat to or removes heat from a thermoelectric module will be referred to as a "thermal element."

The assembly shown in Figure 18 may also be subject to a compressive force F, for example supplied by a clamping arrangement not shown. A compressive force helps ensure that heat source **1801** and heat sink **1802** make good thermal contact with thermoelectric module **1800,** minimizing the thermal resistance at the interfaces.

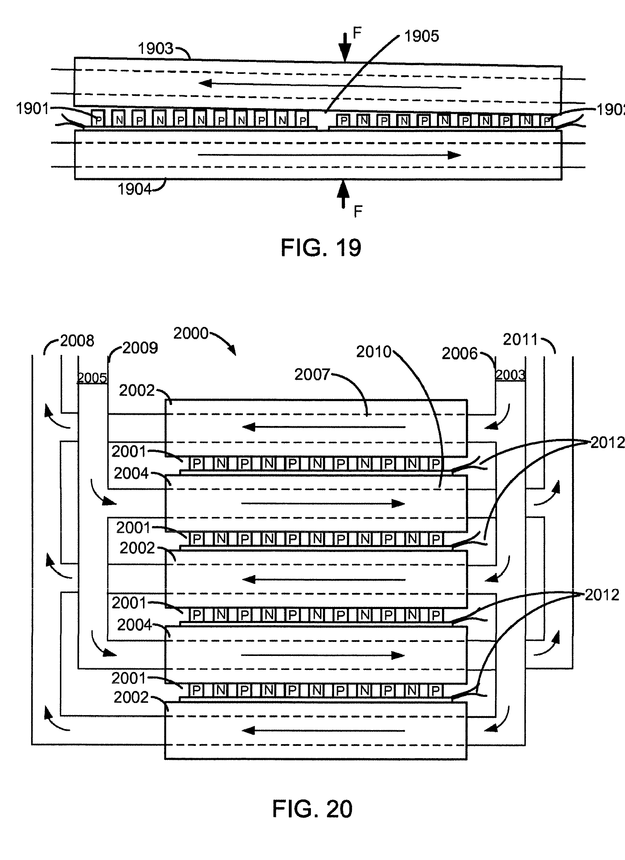

If the outputs of more than one thermoelectric module are to be combined, it is preferable that the complexity of fluid and electrical connections be minimized, and that each thermoelectric module makes good thermal contact with a heat source and a heat sink. Achieving good thermal contact for all thermoelectric modules may be complicated by the variability of dimensions inherent in any manufacturing process. For example, not all thermoelectric modules may be of the same height. **Figure 19** shows one possible consequence of placing two thermoelectric modules **1901, 1902** of different heights between a single hot thermal element **1903** and a single cold thermal element **1904.** (The difference in height between thermoelectric modules **1901** and **1902** is somewhat exaggerated in Figure 19.) As is easily seen, it may not be possible to achieve planar contact with all of the surfaces of thermoelectric modules **1901** and **1902,** and the heat transfer between thermoelectric modules **1901** and **1902** and thermal elements **1903** and **1904** may be compromised. Gaps such as gap **1905** may be formed, ultimately resulting in poor power generation performance of the system. Increasing the compressive force F may improve contact between the system components by bending or conforming the components, but excessive forces may result in damage to the various components.

One approach to this problem is described in co-pending U.S. patent application 10/823,353, filed April 13, 2004 and titled "Same Plane Multiple Thermoelectric Mounting System", the disclosure of which application is hereby incorporated herein in its entirety for all purposes. That application describes an arrangement in which at least some of the thermal elements are configurable to accommodate tolerance variations in the system components, enabling the efficient coupling of multiple thermoelectric modules.

**Figure 20** illustrates a thermoelectric generator **2000** in accordance with an embodiment. For the purposes of this disclosure, a "thermoelectric generator" is an arrangement of one or more thermoelectric modules and other components that generates electric power using the thermoelectric effect. Each thermoelectric module may be made up of a plurality of thermoelectric elements, arranged in thermoelectric couples.

Example thermoelectric generator **2000** includes a plurality of thermoelectric modules **2001.** Each thermoelectric module **2001** generates electrical power when subjected to a temperature differential between its two sides. Thermoelectric generator **2000** also includes a plurality of first thermal elements **2002** to which heat is supplied by a first fluid **2003,** and a plurality of second thermal elements **2004,** from which heat is removed by a second fluid **2005.** The first and second thermal elements **2002** and **2004** are arranged in a stack of alternating first and second thermal elements, with a thermoelectric module **2001** sandwiched between each adjacent pair of a first thermal element **2002** and second thermal element **2004.** While only four thermoelectric modules **2001** are shown in Figure, with three first thermal elements **2002** and two second thermal elements **2004,** one of skill in the art will recognize that more or fewer thermoelectric modules may be used.

Other than the first thermal elements on the ends of the stack, each first thermal element **2002** is then in contact with two of thermoelectric modules **2001,** one at each of two opposing faces of the respective first thermal element **2002.** Similarly, each second thermal element **2004** is in contact with two of thermoelectric modules **2001,** one at each of two opposing faces of the respective second thermal element **2004.** However, no face of any thermal element is in contact with more than one thermoelectric module **2001.** In this way, efficient use of the thermal elements **2002, 2004** is made, but manufacturing variances in the components are tolerated. Height variations in the thermoelectric modules **2001** do not compromise the system performance, because each face of the thermal elements **2002, 2004** need only conform flatly to one side of one thermoelectric module **2001.** The thermoelectric modules **2001** and thermal elements **2002, 2004** are free to conform in various translational and rotational degrees of freedom during assembly to accomplish the conformance.

Thermal elements **2002, 2004** may be made from a thermally conductive material, such as a metal. Aluminum is a preferred material, due to its high thermal conductivity and resistance to corrosion. Example thermal elements will be described in more detail below.

First fluid **2003** is distributed to the first thermal elements **2002** by a first fluid inlet manifold **2006.** First fluid **2003** may be, for example, water that has been heated for the purpose of generating electric power from thermoelectric generator **2000,** waste hot water from a industrial process, or from some other source. First fluid **2003** may be another kind of fluid, for example a natural or synthetic oil, or any other kind of suitable fluid. For the purposes of this disclosure, the term "fluid" is intended to be interpreted broadly, and encompasses liquids such as water, oil, or other liquids, and encompasses gasses such as air, steam, and other gasses. First fluid **2003** preferably passes through a passageway in each of first thermal elements **2002,** exemplified by passageway **2007.** After passing through first thermal elements **2002,** first fluid **2003** is collected by a first fluid outlet manifold **2008** to be carried away from thermoelectric generator **2000.** Fluid **2003** may be returned to a heating system, or simply exhausted from the system.

Similarly, second fluid **2005** is distributed to second thermal elements **2004** by a second fluid inlet manifold **2009.** Second fluid **2005** is at a different temperature than first fluid **2003,** and may be of the same kind as first fluid **2003,** or may be a different kind of fluid. For example, both first and second fluids **2003** and **2005** may be water, or one may be water while the other is a kind of oil. Any suitable combination is possible. Preferably, second fluid **2005** passes through passageways in second thermal elements **2004,** exemplified by passageway **2010.** After passing through second thermal elements **2004,** second fluid **2005** is collected by a second fluid outlet manifold **2011,** to be carried away. Second fluid **2005** may be recycled, or exhausted from the system.

The net result is that each of thermoelectric modules **2001** is exposed to a temperature differential, by virtue of being between one of first thermal elements **2002** and one of second thermal elements **2004.** Thermal energy flowing through each thermoelectric module **2001** is converted to electrical energy, and a voltage is developed across each set of electrical leads **2012.** In some embodiments, leads **2012** may be interconnected such that thermoelectric generator **400** produces a single voltage on a single set of leads. For example, thermoelectric modules **2001** may be connected in series, so that thermoelectric generator **2000** produces a voltage that is the sum of the voltages produced by the individual thermoelectric modules **2001.**

While a particular arrangement of components has been described above, one of skill in the art will recognize that variations are possible within the scope of the claims. For example, thermoelectric generator **2000** has been described has having "hot" first thermal elements **2002** and "cold" second thermal elements **2004.** This relationship may be reversed, so that the end thermal elements are "cold". Similarly, thermoelectric generator **2000** is shown having first fluid **2003** and second fluid **2005** flowing counter to each other through the thermal elements **2002, 2004.** That is, as shown in Figure 20, first fluid **2003** flows right-to-left through first thermal elements **2002,** and second fluid **2005** flows left-to-right through second thermal elements **2004.** In some embodiments, the fluids could flow in the same direction, or in parallel flow. Many other variations are possible. For example, the passageways **2007, 2010** in the first and second thermal elements **2002, 2004** may be oriented perpendicular to each other, or in some other orientation. One preferred arrangement is described in more detail below.

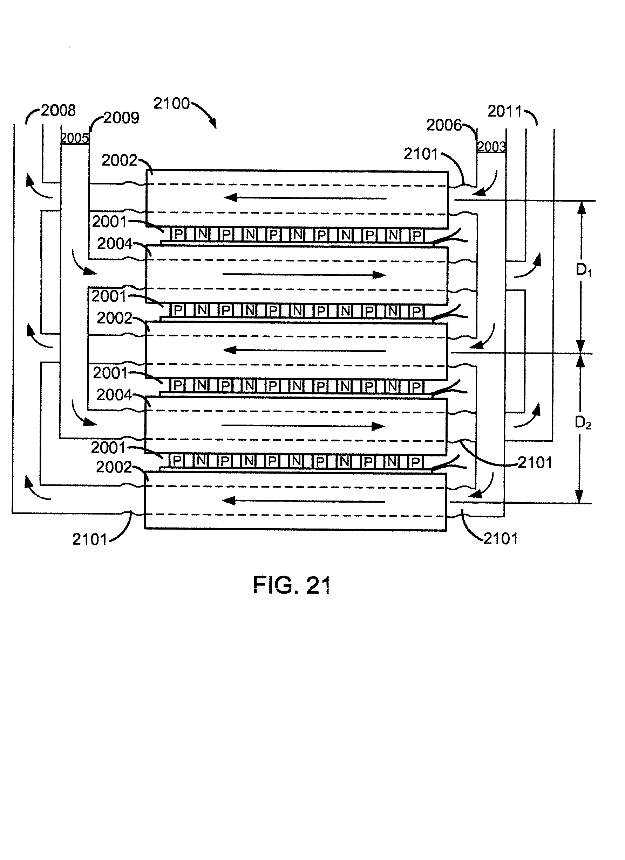

**Figure 21** shows a schematic view of a thermoelectric generator **2100** in accordance with another embodiment. While the stacked orientation of the thermoelectric modules **2001** and thermal elements **2002, 2004,** enables good thermal contact in spite of variations in the dimensions of the various components, these variations may also affect other aspects of the assembly. For example, as shown in Figure 21, the spacings of the passageways through thermal elements **2002, 2004,** may vary. Two of these distances are labeled D₁ and D₂ in Figure 21. If the thermoelectric modules **2001** are not all of the same height, or if there are manufacturing variations in the thermal elements **2002, 2004,** D₁ and D₂ may differ, and ports formed in the manifolds such as first fluid inlet manifold **2006** may be misaligned with the passageways. Because the spacing is not predictable without extensive measuring and sorting of the individual components, it is preferable to accommodate these variations as well. In Figure 21, the thermal elements **2002, 2004** are connected to the manifolds **2006, 2008, 2009, 2011,** through flexible tubes **2101.** (Not all of the flexible tubes are labeled in Figure 21). Flexible tubes **2101** may be made, for example, of rubber or plastic tubing that is easily conformable to accommodate small displacements between the passageways in thermal elements **2002**, **2004** and openings in the manifolds **2006, 2448, 2009, 2011.**

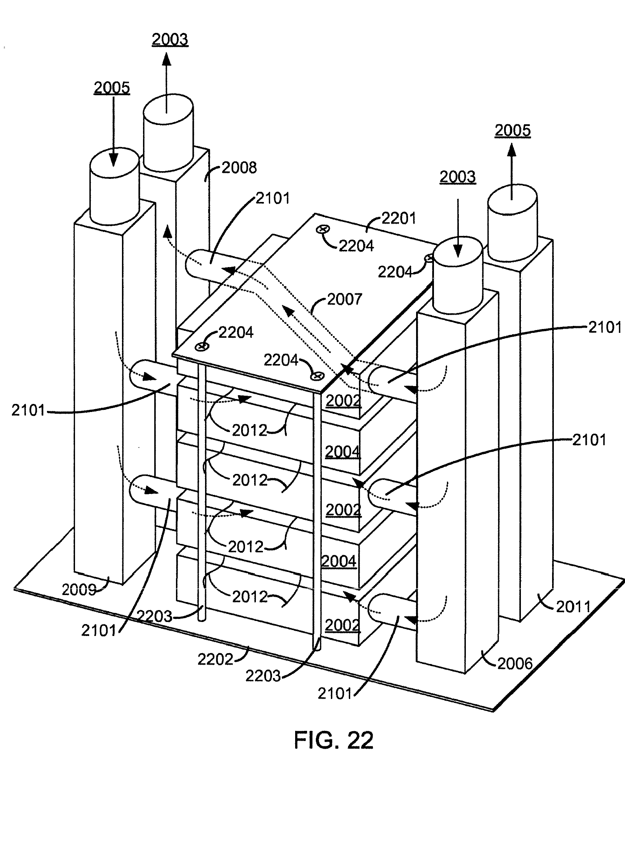

**Figure 22** shows an oblique view of the thermoelectric generator of Figure 21. Thermoelectric modules **2001** are not visible in Figure 22, other than that their electrical leads **2012** are shown protruding from between adjacent pairs of first thermal elements **2002** and second thermal elements **2004.** First fluid **2003** enters first fluid inlet manifold **2006,** flows through some of flexible tubes **2101,** through first thermal elements **2002,** through more of flexible tubes **2101** into first fluid outlet manifold **2008,** and out of the system. Similarly, second fluid **2005** enters second fluid inlet manifold **2009,** flows through some of flexible tubes **2101,** through second thermal elements **2002,** though more of flexible tubes **2101** into second fluid outlet manifold **2011,** and out of the system. For clarity of illustration, flexible tubes **2101** are shown in Figure 22 as having appreciable length, with the various manifolds being held a distance away from the thermal elements. In practice, it is preferable to make flexible tubes short, in order to reduce surface area from which usable thermal energy may be lost. In one example embodiment, manifolds **2006, 2008, 2009, 2011** are made of one inch (25.4 mm) square tubing, and only about ¼ inch (6.35 mm) of each of flexible tubes **2101** is exposed between its respective manifold and thermal element.

In one arrangement, the fluids pass through their respective thermal elements generally diagonally. As is shown in Figure 22, passageway **2007** crosses the top first thermal element **2002** generally from one corner to the opposite corner. This arrangement ensures that first fluid **2003** imparts heat to the first thermal elements **2002** near the center of the thermoelectric modules, and also provides a relatively large contact surface between the fluid **2003** and each of thermal elements **2002**. The remaining first thermal elements **2002** are preferably arranged in the same orientation. Second thermal elements **2004** may be flipped, so that their internal passageways (not shown in Figure 22) also cross the second thermal elements **2004** generally diagonally, and cross the passageways of the first thermal elements **2002**. The first and second thermal elements **2002, 2004** may be mechanically the same, and the criss-cross fluid flow accomplished by simply flipping the second thermal elements **2004** upside down with respect to the first thermal elements **2002**. More detail about the thermal elements will be given below.

Figure 22 also illustrates a clamp that holds the stack of thermoelectric modules and first and second thermal elements in compression. In the example embodiment shown, an upper plate **2201** and a lower plate **2202** are tied together by rods **2203**, which are held in tension by screws **204**. Many other clamping arrangements are possible. For example, rods **2203** may be threaded rods, and a nut at each end may draw plates **2201** and **2202** together. In another embodiment, one or more springs may be attached between plates **2201** and **2202**. Many other mechanisms are possible for holding the modules in compression.

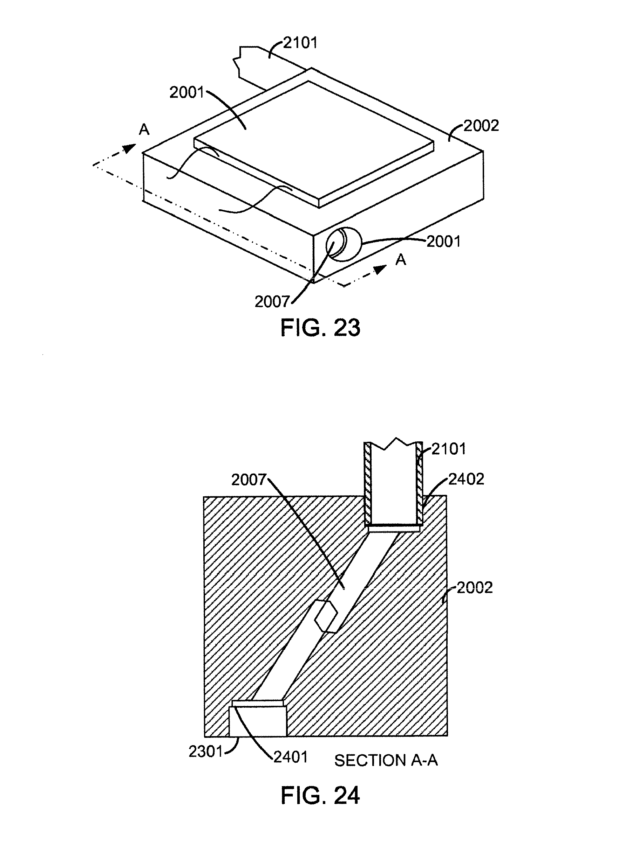

**Figure 23** shows an oblique view of one of first thermal elements **2002**, in accordance with an embodiment. A thermoelectric module **2001** (simplified in Figure 23) is shown as it may be positioned with respect to element **2002**. An opening **2301** is visible on one face, leading to a passageway **2007** through element **2002**. Passageway **2007** leads generally diagonally to a complementary opening on the opposite face of element **2007**. A section of flexible tube **2101** is shown protruding from the opening in the opposite side of element **2002.** **Figure 24** shows first thermal element **2002** in cross section, and more clearly illustrates the internal structure of element **2002.** Opening **2301** may be a stepped hole including a lead-in portion that is of a larger diameter than the midportion of the passageway, providing a shoulder **2401** against which a tube such as flexible tube **2101** may abut when the tube is inserted into opening **2301**. Shoulder **2401** can thus aid in the proper assembly of thermoelectric generator **2000**. Passageway **2007** passes entirely through element **2002**, reaching a similar stepped opening **2402** at the other side of element **2002**. Passageway **2007** may be formed, for example, by drilling or boring overlapping holes from openings **2301** and **2402**.

The generally diagonal traverse of element **2002** by passageway **2007** enables identical mechanical parts to be used for first thermal elements **2002** and second thermal elements **2004.** In other words, the first and second thermal elements **2002, 2004** are mechanically interchangeable. First thermal elements **2002** and second thermal elements **2004** are simply flipped with respect to each other, so that their respective passageways cross. When thermoelectric modules **2001** are positioned as shown in Figure 23, the diagonal passageways traverse the thermal elements generally across the longest dimension of the thermoelectric modules **2001.**

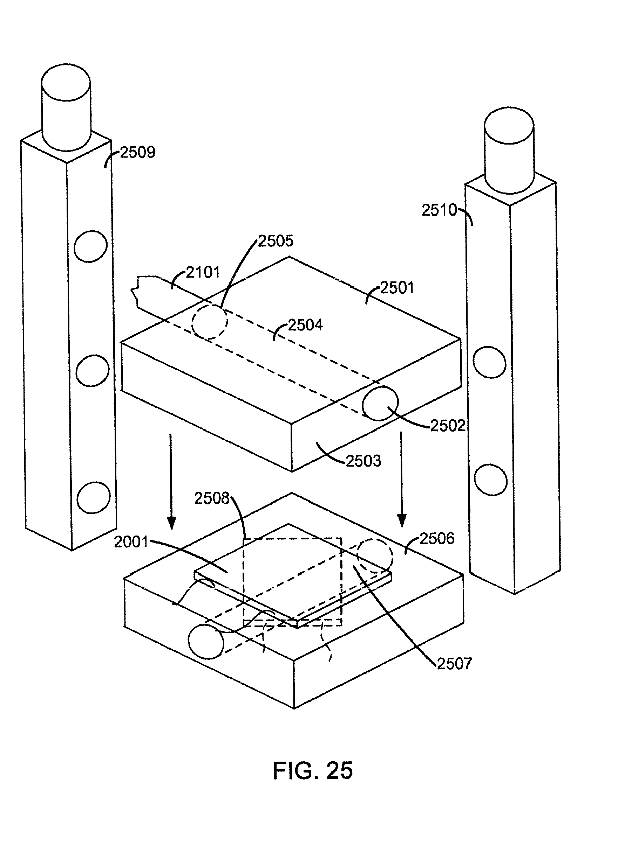

Many other arrangements are possible. For example, the passageways through the thermal elements may be orthogonal to the sides of the thermal elements. **Figure 25** illustrates this arrangement, in a partially exploded oblique view. In Figure 25, first thermal element **2501** includes an opening **2502** in face **2503,** leading to a passageway **2504** that traverses thermal element **2501** generally orthogonally to face **2503.** Although not illustrated in Figure 25, opening **2502** and other similar openings may be stepped openings. Passageway **2504** leads to a complementary opening **2505** on the opposite face of thermal element **2501.** A section of flexible tubing **2101** is shown protruding from complementary opening **2505.** A second thermal element **2506** may be mechanically interchangeable with first thermal element **2501,** but flipped or rotated so that its passageway **2507** is perpendicular to passageway **2504** in first thermal element **2501.** A thermoelectric module **2001** is sandwiched between first and second thermal elements **2501** and **2506.** These components may be part of a larger stack of alternating first and second thermal elements **901, 906** with a thermoelectric module **401** between each adjacent pair of thermal elements **901, 906.** In this embodiment, manifolds would be placed one at each side of the stack of thermal elements **2501, 2506,** rather than in pairs on two sides of the stack as was shown in Figure 22. Two manifolds **2509, 2510** are shown in Figure 25. The thermoelectric modules may be placed in alignment with the thermal elements, as thermoelectric module **2001** is shown aligned with thermal element **2506** in Figure 25. Alternatively, the thermoelectric modules may be rotated with respect to the thermal elements, in the arrangements shown by phantom thermoelectric module **2508** in Figure 25. This arrangement positions the thermoelectric modules such that the passageways **2504, 2507** traverse the thermoelectric modules generally diagonally, if desired.

In other embodiments, the various connections between the components may be made in any number of ways. One method of connecting flexible tubes **2101** to thermal elements **2002, 2004** was illustrated in Figure 24. Referring again to Figure 24, preferably openings **2301** and **2402** and tubing **2101** are sized such that inserting a piece of tubing **2101** into one of the openings results in a secure press fit. In some embodiments, the fluids passing through thermal elements **2002, 2004** need not be at a high pressure, so that a light press fit may suffice to prevent leakage of fluid from the connections. Similar press fits may be used to connect sections of tubing **2101** to the manifolds, such as manifolds **2006, 2008, 2009,** and **2011.** Such press fits, with the flexible tubes **2101** pressed into relatively rigid materials used for the manifolds and thermal elements, may accommodate pressure fluctuations well, as higher pressure in the flexible tubes **2101** tends to improve the seal between the tubes and the receptacles into which the tubes are inserted. Preferably, flexible tubes **2101** are made as short as possible, while still accommodating the tolerance variations, in order to help maximize the efficiency of thermoelectric generator **2000** by minimizing heat loss from the hotter fluid to the surrounding environment, or heat gain into the colder fluid. For example, when ½ inch (12.7 mm) plastic or rubber tubing is used for flexible tubes **2101,** as little as ¼ inch (6.35 mm) or less of tubing may be exposed between each respective manifold and thermal element.

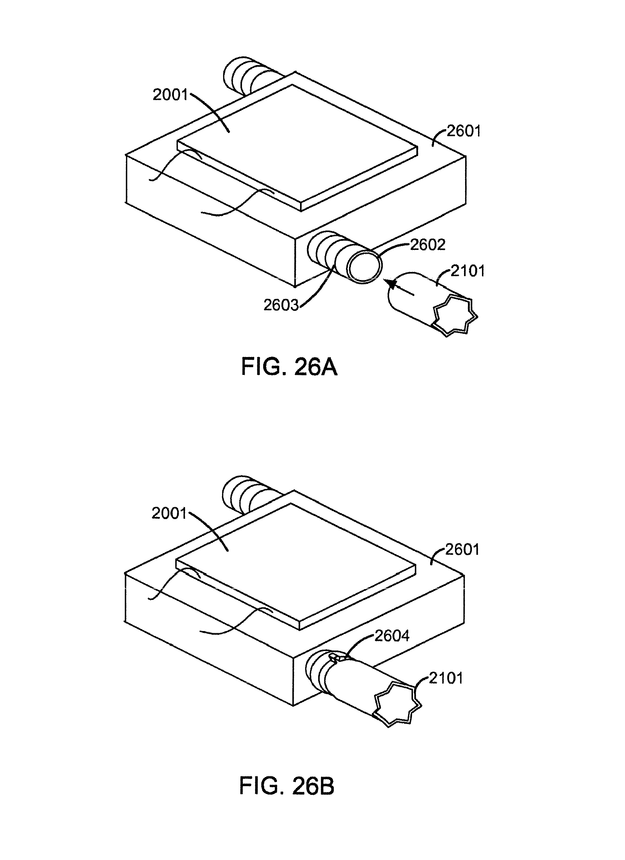

**Figures 26A and 26B** illustrate another method of making connections between flexible tubes **2101** and the thermal elements, represented by thermal element **2601.** In this embodiment, thermal element **2601** comprises a substantially rigid protruding tube **2602,** over which a section of flexible tubing **2101** may be clamped or otherwise fitted. For example, tube **2602** may be a metal or plastic tube that is press fit into a stepped opening in thermal element **2601,** or threaded into a threaded hole in thermal element **2601.** Tube **2602** may include serrations or ridges **2603** on its outer surface, for gripping and sealing to tubing **2101.** If tube **2602** and thermal element **2601** are both made of metal, they may be made of the same metal in order to reduce the possibility of corrosion in the system. Alternatively, tube **2602** may be made of a polymer, such as nylon, polyvinylchloride, acetal, or another suitable polymer. In Figure 26A, tube 2101 is shown poised for connection to tube **2602.** In Figure 26B, tube **2101** has been assembled to tube **2602,** and an optional clamp **2604** affixed to help ensure a secure and leak-free fit. Example clamp **2604** is affixed by crimping, but many other kinds of clamps are possible, including spring clamps, clamps that are tightened by use of a screw or bolt, or other kinds of clamps.

Similar kinds of connections may be used to connect flexible tubes **2101** to the fluid inlet and outlet manifolds, such as manifolds **2006, 2008, 2009,** and **2011.** That is, tubes **2101** may be pressed, threaded, or otherwise inserted into openings in the manifolds, may be fitted over tubes protruding from the manifolds, with or without clamps, or may be connected in any other suitable way. Combinations of connection types may be used. For example, the connections to the thermal elements may be of one type, while the connections to the manifolds may be of another type. Connection types may also be mixed within the connections to the thermal elements, within the connections to the manifolds, or both.

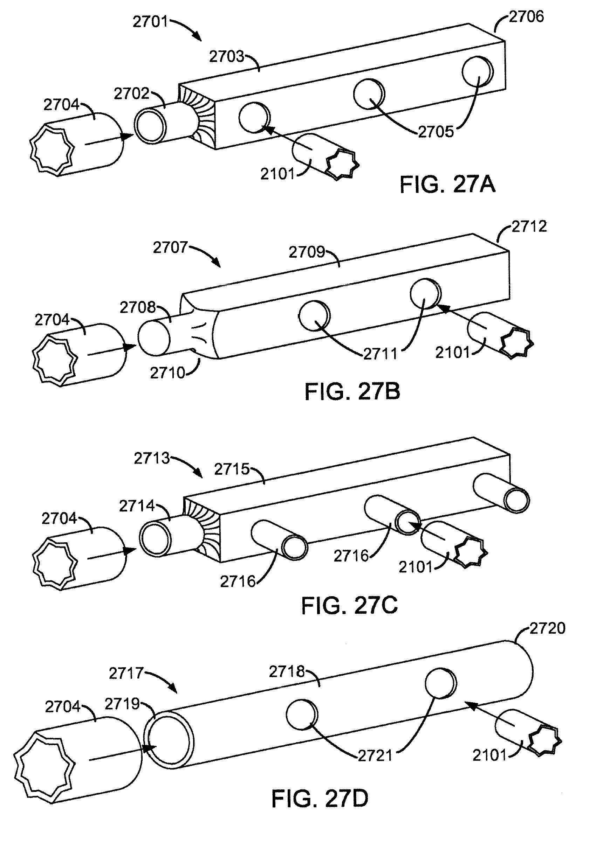

**Figures 27A-27D** illustrate several ways of making manifolds such as manifolds **2006, 2008, 2009, 2011,** in accordance with embodiments of the invention. In the embodiment of Figure 27A, a manifold **2701** includes a round tube segment **2702** that is welded or brazed into a square tube **2703.** Round tube **2702** is convenient, for example, for receiving a tube or hose **2704** that in operation supplies fluid to or receives fluid from manifold **2701.** Hose or tube **2704** may be compression fit, clamped, or otherwise connected to round tube **2702.** Preferably, round tube **2702** and square tube **2703** are made of the same metal, so that the risk of corrosion may be reduced in the system. Square tube **2703** also includes side holes **2705** for receiving flexible tubes **2101** that lead to their respective thermal elements. The number of side holes **2705** will depend on the number of thermal elements in the stack of thermal elements in the particular thermoelectric generator that manifold **2701** is part of, and on whether the manifold is for the first or second fluid. Distal end **2706** of manifold **2701** may be plugged, capped, crimped, or otherwise sealed.

Figure 27B shows a manifold **2707** in accordance with another embodiment. In this embodiment, manifold **2707** is formed from a single piece of tubing, with a round portion **2708** and a square portion **2709.** The transition **2710** between the round portion **2708** and square portion 2709 may be formed, for example, by a swaging process. Square portion **2709** may include side holes **2711,** and may be sealed at its distal end **2712.**

Figure 27C shows a manifold **2713** in accordance with another embodiment. Manifold **2713** is shown as generally fabricated in the same way as manifold **2701,** with a round tube **2714** welded or brazed into a square tube **2715,** but manifold **2713** may be fabricated in any other suitable way as well. Manifold **2713** includes side tubes **2716** for receiving flexible tubes **2101.** Side tubes **2716** may be, for example, welded or brazed to square portion **2715,** may be pressed or threaded into holes in square portion **2715,** or may be affixed in some other suitable way. Alternatively, manifold **2713** may be molded from a polymer such as nylon, polyvinylchloride, acetal, or another suitable polymer. Round tube **2714,** side tubes **2716,** or both may include serrations or ridges for facilitating the secure connection of hose **2704,** flexible tubes **2101,** or both.

Figure 27D shows a manifold **2717** in accordance with yet another embodiment. Manifold **2717** is made from a single round tube **2718** with an open end **2719** for receiving hose **2704,** and a sealed end **2720.** Side holes **2721** receive flexible tubes **2101** in any suitable manner as needed.

While several example manifolds have been described, it is to be understood that these are examples, and other arrangements using different combinations of features and fabrication techniques may be envisioned within the scope of the claims.

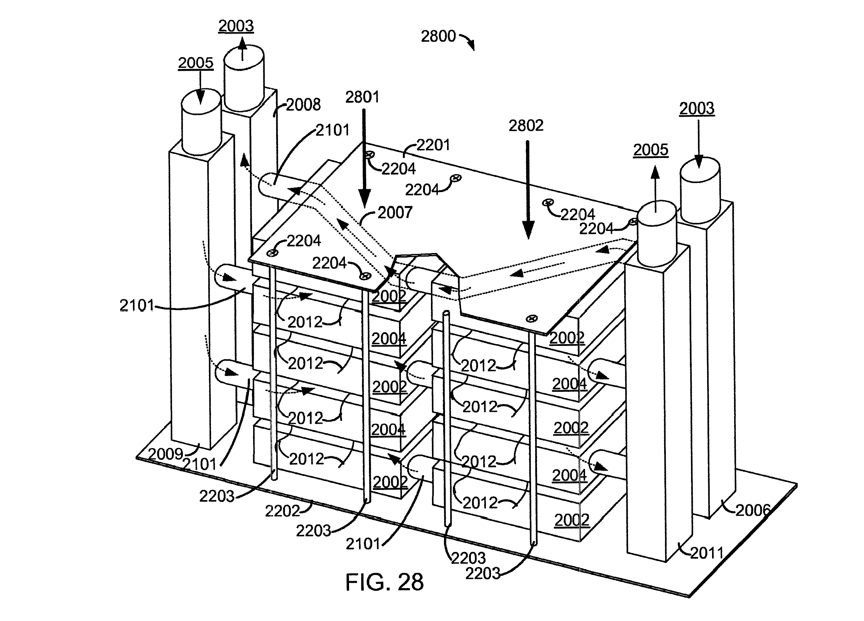

**Figure 28** illustrates a thermoelectric generator **2800** in accordance with another example embodiment. In example thermoelectric generator **2800,** there are two stacks **2801, 2802** of first and second thermal elements **2002, 2004,** and a thermoelectric element **2001** between each vertically-adjacent pair of first and second thermal elements in each stack. (Thermoelectric elements **2001** are visible only by their leads **2012** in Figure 28.) Horizontally-adjacent pairs of first thermal elements **2002** are coupled by a tube **2101,** and horizontally-adjacent pairs of second thermal elements **2004** are likewise coupled. Preferably, tubes **2101** are quite short, to avoid radiant and other heat loss to the surrounding environment. The relative positions of first fluid inlet manifold **2006** and second fluid outlet manifold **2011** are interchanged, as compared with the generator shown in Figure 22. First fluid **2003** thus flows into first fluid inlet manifold **2006,** flows serially through first thermal elements **2002,** and out of first fluid outlet manifold **2008.** In each of the parallel paths through first thermal elements **2002,** fluid passes through two first thermal elements **2002** in series. Second fluid **2005** follows a similar path through second thermal elements **2004.** Passing through one set of first and second thermal elements **2002, 2004** may reduce the temperature differential between first and second fluids **2003, 2005** by only a small amount, so that passing through another set of first and second thermal elements **2002, 2004** may still produce useful electrical power from a thermoelectric module sandwiched between the second set.

A thermoelectric generator in the configuration of generator **2800** may be especially suitable for systems that do not recirculate the heated or cold fluids. Generator **2800** may produce more electrical energy from a single pass of fluids **2003, 2005** through it as compared with a generator without series-connected thermal elements, although the efficiency of generator **2800** may be slightly reduced. Whether to use series-connected thermal elements or not may be an economic decision based on many factors, such as the cost of thermoelectric modules **2001,** whether fluid is recycled for reheating after passing through the thermoelectric generator, and other factors. One of skill in the art will recognize that any practical number of series-connected columns of thermal elements may be used, and the columns may contain any practical number of thermoelectric elements **2001,** from as few as one and ranging upward. The thermoelectric modules **2001** may be electrically connected in any suitable configuration, including in series, in parallel, or in a combination of serial and parallel connections.

While a thermoelectric generator such as those shown in Figures 22 and 28 combines the electrical outputs of several thermoelectric modules **2001,** this kind of generator may still produce only a few watts of usable electric power. According to statistics published by the Energy Information Administration in the United States, an average US household may use over 10,600 kilowatt-hours of electrical energy per year. This translates to an average continuous power consumption of about 1,200 watts (W) throughout the year. Even if significant conservation measures are implemented, a thermoelectric generator for household use would desirably be able to produce several hundred watts of power.

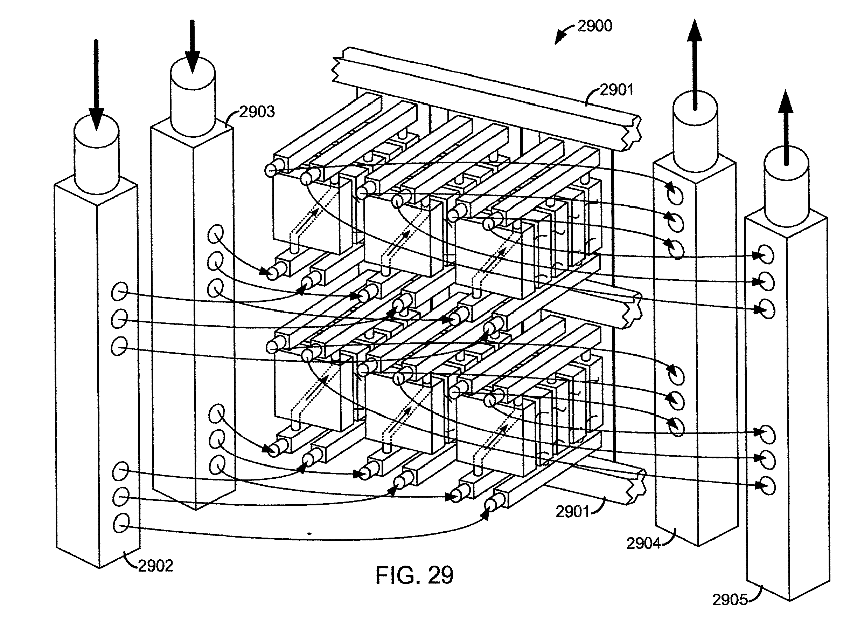

**Figure 29** shows a thermoelectric generator **2900,** in accordance with another embodiment. In thermoelectric generator **2900,** several generators such as those shown in Figures 22 and 28 are further connected. For the purpose of discussing Figure 29, a generator such as is shown in Figures 22 and 28 will be referred to as a "bank". Each bank provides a temperature differential to several thermoelectric elements **2001.** Thermoelectric generator **2900** further connects several banks to further increase the amount of power generated. The banks are mounted in an array on rack **2901,** shown in cutaway view. The inlet and outlet tubes of the various manifolds are thus presented in an array behind rack **2901.**

Fluids are provided to and received from the bank manifolds via large manifolds **2902, 2903, 2904, 2905.** Large manifolds **2902-2905** may be made, for example, of 2-inch (50.8 mm) square tubing with round hose connection tubes formed, welded, or brazed on the ends. The lower ends are crimped, capped, welded shut, or otherwise sealed.

In the example of Figure 29, large manifold **2902** supplies heated fluid to each bank's heated fluid inlet manifold, and large manifold **2903** supplies cold fluid to each bank's respective cold fluid inlet manifold. Large manifolds **2904** and **2905** receive the heated fluid and cold fluid respectively after the fluids have passed through the banks. The various fluid flows are shown only by arrows in Figure 29. No piping or tubing is shown, so as not to obscure the interconnections. One of skill in the art will recognize that tubes, hoses, or pipes will be used to make the actual connections, and that large manifolds **2902-2905** will preferably be positioned close to the banks so as to minimize the loss of usable thermal energy. Using the rack arrangement of Figure 29, many banks, comprising many thermoelectric modules, can be thermally connected. The leads **2012** of the various thermoelectric modules can be conveniently electrically interconnected, so that the system is scalable to produce large amounts of power. (The electrical interconnections are not shown in the Figures.)

The banks of Figure 29 are configured for "parallel" flow heat exchange, with all inlets on the lower sides of the banks, and all outlets on the upper sides of the banks. In this arrangement, all fluid flow through the thermal elements is (diagonally) upward, and entrapment of air in the thermal elements may be minimized or avoided. Air entrapped in the thermal elements can reduce the effectiveness of heat transfer between the respective fluids and thermal elements, and ultimately reduces the power available from the thermoelectric generator.

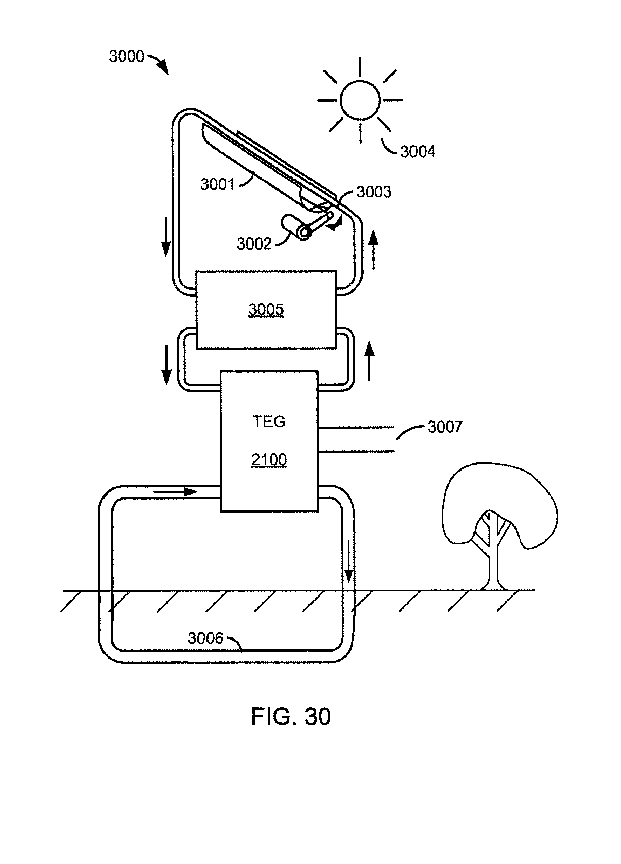

A thermoelectric generator such as thermoelectric generator **2100, 2800,** or **2900** may be especially suited for use when low-cost sources of hot and cold fluids are available. For example, **Figure 30** illustrates the use of thermoelectric generator **2100** in a system **3000** wherein one fluid is heated using solar energy, and another fluid is cooled using an earth-coupled piping loop.

In system **3000,** a solar collector **3001** concentrates incoming energy from the sun **3004** onto a tube **3003** that carries a fluid such as water or an oil. Solar collector **3001** may be driven by a motor **3002** or other actuator to follow the sun during the day, for optimum energy collection. One of skill in the art will recognize that other kinds of solar collectors may be used besides the concentrating trough type collector **3001.** The fluid in tube **3003** heats a reservoir **3005.** Preferably, reservoir **3005** is filled with water, which has good thermal storage characteristics and is inexpensive, although other media could be used. The fluid from reservoir **3006** may be circulated directly through tube **3003,** or may be heated indirectly, such as by a heat exchanger that extracts heat from the fluid in tube **3003** and imparts it to the fluid in reservoir **3005.** Preferably, the fluid in reservoir **3005** is circulated through thermoelectric generator **2100,** providing the "hot" side of a temperature differential from which thermoelectric generator **2100** generates electric power.

While thermoelectric generator **2100** is depicted in Figure 30 as a simple block, it will be recognized that it may include the components shown in Figure 21, including multiple thermoelectric modules, thermal elements, manifolds, and flexible tubing.

In system **3000,** the cold side of the temperature differential is provided by a fluid, preferably water, that is cooled using an earth-coupled piping loop **3006.** Such a loop takes advantage of the fact that at sufficient depths, the underground soil temperature stays relatively constant throughout the year. For example, in some parts of the United States, the underground temperature may be about 54-57 °F (12-14 °C). A sufficiently long earth-coupled loop will exhaust to the earth the heat gathered by the cold fluid during electricity generation in thermoelectric generator **2100,** cooling the fluid so that it can once again provide the cold side of the temperature differential exploited by thermoelectric generator **2100.** Both the hot and cold fluids and the fluid in tube **3003** may be circulated by pumps not shown in Figure 30.

Electric power is thus generated and is available at leads **3007** of thermoelectric generator **2100.** Multiple thermoelectric modules within thermoelectric generator **2100** may be connected in series, parallel, or in a combination of series and parallel connections to provide power having appropriate voltage, current, or other characteristics. One or more components of the system may be configurable to adjust the amount or character of the available power. For example, a matrix switch may be provided that configures the electrical interconnections of the thermoelectric modules or banks of such modules included in thermoelectric generator **2100.** Such configurable components, including a matrix switch, are described above.

The invention has now been described in detail for the purposes of clarity and understanding. However, it will be appreciated that certain changes and modifications may be practiced within the scope of the appended claims.

## Claims

1. A thermoelectric generator for generating electrical power from a difference in temperature, the thermoelectric generator comprising:
a plurality of thermoelectric modules, each thermoelectric module having a first side and a second side, and each thermoelectric module generating electrical power when subjected to a temperature differential between its respective first side and second side;
a plurality of first thermal elements to which heat is supplied by a first fluid;
a plurality of second thermal elements from which heat is removed by a second fluid; and
wherein the first and second thermal elements are arranged in a stack of alternating first and second thermal elements having one of the plurality of thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules;
and wherein the thermoelectric generator is oriented such that both fluids flow through their respective thermal elements in an upward direction.

2. The thermoelectric generator for generating electrical power from a difference in temperature as recited in Claim 1, wherein both fluids flow through their respective thermal elements in a diagonally upward direction; or optionally
wherein each of the first and second thermal elements is a block made of a thermally conductive material, each block further comprising a passageway through the block through which the respective fluid flows.

3. The thermoelectric generator for generating electrical power from a difference in temperature as recited in Claim 2, wherein each block is generally rectangular, and wherein each passageway traverses its respective block generally diagonally; or optionally
wherein each passageway comprises a lead-in portion at each end of the passageway, each lead-in portion being generally cylindrical and of a larger dimension than the midportion of the passageway.

4. The thermoelectric generator for generating electrical power from a difference in temperature as recited in Claim 1, wherein the first and second thermal elements are mechanically interchangeable; or optionally
further comprising:
a first fluid inlet manifold that distributes the first fluid to the first thermal elements;
a first fluid outlet manifold that collects the first fluid from the first thermal elements;
a second fluid inlet manifold that distributes the second fluid to the second thermal elements; and
a second fluid outlet manifold that collects the second fluid from the second thermal elements; and optionally
further comprising one or more flexible tubes, at least one of the tubes connecting each of the manifolds with each of its respective first or second thermal elements.

5. A thermoelectric generator for generating electrical power from a difference in temperature, the thermoelectric generator comprising:
a plurality of thermoelectric modules, each thermoelectric module having a first side and a second side, and each thermoelectric module generating electrical power when subjected to a temperature differential between its respective first side and second side;
a plurality of first thermal elements to which heat is supplied by a first fluid flowing through a first element passageway in each first thermal element, each first element passageway defined by overlapping holes extending from a periphery of the respective first thermal element; and
a plurality of second thermal elements from which heat is removed by a second fluid flowing through a second element passageway in each second thermal element, each second element passageway defined by overlapping holes extending from a periphery of the respective second thermal element;
wherein each thermoelectric element contacts one of the first thermal elements and one of the second thermal elements.

6. A thermoelectric generator for generating electrical power from a difference in temperature, the thermoelectric generator comprising:
a plurality of thermoelectric modules, each thermoelectric module having a first side and a second side, and each thermoelectric module generating electrical power when subjected to a temperature differential between its respective first side and second side;
a plurality of first thermal elements to which heat is supplied by a first fluid via a flexible tube press fit into the respective first thermal element; and
a plurality of second thermal elements from which heat is removed by a second fluid via a flexible tube press fit into the respective second thermal element;
wherein each thermoelectric element contacts one of the first thermal elements and one of the second thermal elements; and optionally
wherein each flexible tube is press fit into a cylindrical lead-in portion of its respective first or second thermal element.

7. The thermoelectric generator for generating electrical power from a difference in temperature as recited in any of Claims 5 or 6, wherein the first and second thermal elements are arranged in a stack of alternating first and second thermal elements having one of the plurality of thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules; or optionally
wherein the thermoelectric generator is oriented such that both fluids flow through their respective thermal elements in an upward direction.

8. A thermoelectric generator for generating electrical power from a difference in temperature, the thermoelectric generator comprising a plurality of banks, each bank comprising
a plurality of thermoelectric modules, each thermoelectric module having a first side and a second side, and each thermoelectric module generating electrical power when subjected to a temperature differential between its respective first side and second side;
a plurality of first thermal elements to which heat is supplied by a first fluid;
a plurality of second thermal elements from which heat is removed by a second fluid;
a first fluid inlet manifold that distributes the first fluid to the first thermal elements;
a first fluid outlet manifold that collects the first fluid from the first thermal elements;
a second fluid inlet manifold that distributes the second fluid to the second thermal elements; and
a second fluid outlet manifold that collects the second fluid from the second thermal elements;
wherein each thermoelectric element contacts one of the first thermal elements and one of the second thermal elements;
and wherein the banks are arranged into an array of banks and are connected both electrically and thermally to form a scalable thermoelectric generator.

9. The thermoelectric generator for generating electrical power from a difference in temperature as recited in Claim 8, further comprising:
a first fluid supply manifold that supplies the first fluid to all of the first fluid inlet manifolds of the banks;
a first fluid receiving manifold that receives the first fluid from all of the first fluid outlet manifolds of the banks;
a second fluid supply manifold that supplies the second fluid to all of the second fluid inlet manifolds of the banks; and
a second fluid receiving manifold that receives the second fluid from all of the second fluid outlet manifolds of the banks.

10. The thermoelectric generator for generating electrical power from a difference in temperature as recited in Claim 8 or Claim 9, wherein, within each bank, the first and second thermal elements are arranged in a stack of alternating first and second thermal elements having one of the plurality of thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules.

11. The thermoelectric generator for generating electrical power from a difference in temperature as recited in any of Claims 8 - 10, wherein the thermoelectric generator is oriented such that both fluids flow through their respective thermal elements in an upward direction.

12. A method of fabricating a thermoelectric generator for generating electrical power from a difference in temperature, the method comprising:
providing a plurality of thermoelectric modules, each thermoelectric module having a first side and a second side, and each thermoelectric module generating electrical power when subjected to a temperature differential between its respective first side and second side;
providing a plurality of first thermal elements configured to receive heat from a first fluid;
providing a plurality of second thermal elements configured to be cooled by a second fluid;
arranging the first and second thermal elements in a stack of alternating first and second thermal elements having one of the thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules; and
orienting the thermoelectric generator such that the first a second fluids flow through their respective first and second thermal elements in an upward direction; and optionally
wherein orienting the thermoelectric generator such that the first a second fluids flow through their respective first and second thermal elements in an upward direction comprises orienting the thermoelectric generator such that the first a second fluids flow through their respective first and second thermal elements in a diagonally upward direction.

13. The method of fabricating a thermoelectric generator for generating electrical power from a difference in temperature as recited in Claim 12, the method further comprising:
providing a first fluid inlet manifold configured to receive the first fluid and distribute it to the plurality of first thermal elements;
providing a second fluid inlet manifold configured to receive the second fluid and distribute it to the plurality of second thermal elements;
providing a first fluid outlet manifold configured to receive the first fluid from the plurality of first thermal elements and carry the first fluid away from the thermoelectric generator; and
providing a second fluid outlet manifold configured to receive the second fluid from the plurality of second thermal elements and carry the second fluid away from the thermoelectric generator.

14. A method of fabricating a thermoelectric generator for generating electrical power from a difference in temperature, the method comprising:
providing a plurality of thermoelectric modules, each thermoelectric module having a first side and a second side, and each thermoelectric module generating electrical power when subjected to a temperature differential between its respective first side and second side;
providing a plurality of first thermal elements configured to receive heat from a first fluid;
forming a first element passageway in each first thermal element to receive the first fluid, each first element passageway defined by overlapping holes extending from a periphery of the respective first thermal element;
providing a plurality of second thermal elements configured to be cooled by a second fluid;
forming a second element passageway in each second thermal element to receive the second fluid, each second element passageway defined by overlapping holes extending from a periphery of the respective second thermal element; and
placing each thermoelectric element in contact with a first thermal element and a second thermal element.

15. A method of fabricating a thermoelectric generator for generating electrical power from a difference in temperature, the method comprising:
providing a plurality of thermoelectric modules, each thermoelectric module having a first side and a second side, and each thermoelectric module generating electrical power when subjected to a temperature differential between its respective first side and second side;
providing a plurality of first thermal elements configured to receive heat from a first fluid;
providing a plurality of second thermal elements configured to be cooled by a second fluid;
placing each thermoelectric element in contact with a first thermal element and a second thermal element;
providing a plurality of flexible tubes to deliver the first and second fluids to the first and second thermal elements; and
connecting at least one flexible tube to each first and second thermal element by press fitting an end of the flexible tube into a cylindrical lead-in portion of the respective first or second thermal element.

16. A method of fabricating a thermoelectric generator for generating electrical power from a difference in temperature, the method comprising:
providing a plurality of banks, each bank comprising
a plurality of thermoelectric modules, each thermoelectric module having a first side and a second side, and each thermoelectric module generating electrical power when subjected to a temperature differential between its respective first side and second side,
a plurality of first thermal elements to which heat is supplied by a first fluid,
a plurality of second thermal elements from which heat is removed by a second fluid,
a first fluid inlet manifold that distributes the first fluid to the first thermal elements;
a first fluid outlet manifold that collects the first fluid from the first thermal elements;
a second fluid inlet manifold that distributes the second fluid to the second thermal elements; and
a second fluid outlet manifold that collects the second fluid from the second thermal elements;
wherein each thermoelectric element contacts one of the first thermal elements and one of the second thermal elements; and
arranging the banks into an array of banks and are connected both electrically and thermally to form a scalable thermoelectric generator.

17. The method of fabricating a thermoelectric generator for generating electrical power from a difference in temperature as recited in Claim 16, the method further comprising:
providing a first fluid supply manifold that supplies the first fluid to all of the first fluid inlet manifolds of the banks;
providing a first fluid receiving manifold that receives the first fluid from all of the first fluid outlet manifolds of the banks;
providing a second fluid supply manifold that supplies the second fluid to all of the second fluid inlet manifolds of the banks; and
providing a second fluid receiving manifold that receives the second fluid from all of the second fluid outlet manifolds of the banks.

18. The method of fabricating a thermoelectric generator for generating electrical power from a difference in temperature as recited in Claim 16 or Claim 17, the method further comprising, within each bank, arranging the first and second thermal elements in a stack of alternating first and second thermal elements having one of the thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules.

19. The method of fabricating a thermoelectric generator for generating electrical power from a difference in temperature as recited in any of Claims 16 - 18, further comprising orienting the thermoelectric generator such that the first and second fluids flow through their respective first and second thermal elements in an upward direction.

20. An integrated energy system for a building, the system comprising:
at least one reservoir of thermal energy;
at least one solar collector that provides heat to the reservoir;
at least one environment-coupled piping loop through which a cooling fluid is circulated such that heat is exhausted from the cooling fluid to the environment;
a thermoelectric generator that generates electric power from a temperature differential between the reservoir of thermal energy and the cooling fluid; and
at least one hydronic heating unit through which heated fluid is piped, providing space heating to at least one space in the building, the heated fluid deriving its heat from the reservoir of thermal energy.

21. The integrated energy system for a building of claim 20, further comprising at least one hydronic cooling loop through which at least some of the cooling fluid is piped, providing space cooling to at least one space in the building.

22. The integrated energy system for a building of claim 20, further comprising:
a backup heater that provides heat to the reservoir of thermal energy, supplementing the solar collector.

23. The integrated energy system for a building of claim 22, wherein the backup heater derives heat from a fossil fuel.

24. The integrated energy system for a building of claim 20, further comprising a tank of hot water designated for domestic hot water use.

25. The integrated energy system for a building of claim 20, further comprising a backup domestic water heater that supplies heat to hot water designated for domestic hot water use when insufficient energy is otherwise available.

26. The integrated energy system for a building of claim 25, wherein the backup domestic water heater comprises at least one on-demand heater.

27. The integrated energy system for a building of claim 25, wherein the backup domestic water heater derives heat from a fossil fuel.

28. The integrated energy system for a building of claim 20, further comprising a direct-current power grid within the building.

29. The integrated energy system for a building of claim 20, further comprising an inverter that converts direct-current power from the thermoelectric generator to alternating-current power.

30. The integrated energy system for a building of claim 20, wherein the thermoelectric generator comprises a plurality of banks, the integrated energy system further comprising:
a thermoelectric generator controller; and
a matrix switch that, under control of the thermoelectric generator controller, configures the interconnection of the banks.

31. The integrated energy system for a building of claim 20, further comprising a load controller that at least temporarily prevents the operation of at least one load based in part on the amount of electrical power being consumed by other loads.

32. The integrated energy system for a building of claim 20, further comprising a load controller that constrains at least one appliance to operate only during certain predetermined time intervals.

33. The integrated energy system for a building of claim 20, further comprising a backup connection to the mains power grid, the backup connection providing electrical power to the building to supplement the thermoelectric generator.

34. The integrated energy system for a building of claim 20, further comprising a hydrogen generator powered by electricity from the thermoelectric generator.

35. The integrated energy system for a building of claim 34, further comprising a backup domestic water heater, and wherein the backup domestic water heater derives heat from hydrogen generated by the hydrogen generator.

36. The integrated energy system for a building of claim 20, wherein the reservoir of thermal energy comprises a tank of heated water.

37. The integrated energy system for a building of claim 20, wherein a medium in the reservoir of thermal energy is heated directly by the solar collector.

38. The integrated energy system for a building of claim 20, wherein a medium in the reservoir of thermal energy is heated though a heat exchanger carrying a second medium heated by the solar collector.

39. The integrated energy system for a building of claim 20, wherein the heated fluid circulated through the at least one hydronic heating unit derives its heat from the reservoir of thermal energy through a heat exchanger.

40. The integrated energy system for a building of claim 20, wherein the at least one environment-coupled piping loop comprises a deep earth-coupled piping loop.

41. The integrated energy system for a building of claim 20, wherein the at least one environment-coupled piping loop comprises a shallow earth-coupled piping loop.

42. The integrated energy system for a building of claim 20, wherein the at least one environment-coupled piping loop comprises an air-coupled piping loop.

43. A method of operating an energy system in a building, the method comprising:
heating a reservoir of thermal energy using a solar collector;
circulating heated fluid through a hydronic heating loop, providing space heating to at least one space in the building, the heated fluid deriving its heat from the reservoir of thermal energy;
circulating a cooling fluid through an environment-coupled piping loop such that heat is exhausted from the cooling fluid to the environment; and
generating electrical power in a thermoelectric generator subjected to a temperature differential between reservoir and the cooling fluid.

44. The method of operating an energy system in a building of claim 43, further comprising:
circulating at least some of the cooling fluid through a hydronic cooling loop, providing space cooling to at least one space in the building.

45. The method of operating an energy system in a building of claim 43, further comprising:
generating hydrogen using electrical energy generated by the thermoelectric generator.

46. The method of operating an energy system in a building of claim 43, further comprising:
storing, separately from the reservoir of thermal energy, water designated for domestic hot water use.

47. The method of operating an energy system in a building of claim 46, further comprising heating the water designated for domestic hot water use with heat from the reservoir of thermal energy.

48. The method of operating an energy system in a building of claim 43, further comprising dynamically configuring, using a thermoelectric generator controller, interconnections of thermoelectric modules within the thermoelectric generator.

49. The method of operating an energy system in a building of claim 43, further comprising temporarily preventing the operation of at least one electrical load based in part on the amount of electrical power being consumed by other loads.

50. The method of operating an energy system of claim 43, wherein circulating the cooling fluid through an environment-coupled piping loop comprises circulating the cooling fluid through an earth-coupled piping loop.

51. An apparatus for automatically configuring a thermoelectric power generation system in accordance with the requirements of a load, the apparatus comprising:
a thermoelectric generator that generates electric power when subjected to a temperature differential;
at least one configurable component that affects at least one aspect of the power generated by the thermoelectric generator;
a monitor that senses at least one aspect of the power generated by the thermoelectric generator and provides at least one signal characterizing the power generated by the thermoelectric generator; and
a controller configured to receive the at least one signal and configure the at least one configurable component based on the at least one signal in accordance with the requirements of a load to which power is supplied by the thermoelectric generator.

52. The apparatus for automatically configuring a thermoelectric power generation system in accordance with the requirements of a load as recited in claim 51, wherein the controller comprises:
a microprocessor; and
a memory holding instructions executable by the microprocessor to receive the at least one signal and configure the at least one configurable component based on the at least one signal in accordance with the requirements of a load to which power is supplied by the thermoelectric generator.

53. The apparatus for automatically configuring a thermoelectric power generation system in accordance with the requirements of a load as recited in claim 51, wherein the temperature differential is provided by a supply of heated fluid and a relatively cold sink, and wherein the at least one configurable component further comprises a valve that, under control of the controller, adjusts a flow rate of the heated fluid.

54. The apparatus for automatically configuring a thermoelectric power generation system in accordance with the requirements of a load as recited in claim 51 , wherein the temperature differential is provided by a supply of heated fluid and a relatively cold sink, and wherein the at least one configurable component further comprises a valve that, under control of the controller, adjusts the temperature of the heated fluid.

55. The apparatus for automatically configuring a thermoelectric power generation system in accordance with the requirements of a load as recited in claim 51, wherein the temperature differential is provided by a relatively hot source and a supply of relatively cold fluid, and wherein the at least one configurable component further comprises a valve that, under control of the controller, adjusts a flow rate of the relatively cold fluid.

56. The apparatus for automatically configuring a thermoelectric power generation system in accordance with the requirements of a load as recited in claim 51, wherein the temperature differential is provided by a relatively hot source and a supply of relatively cold fluid, and wherein the at least one configurable component further comprises a valve that, under control of the controller, adjusts the temperature of the relatively cold fluid.

57. The apparatus for automatically configuring a thermoelectric power generation system in accordance with the requirements of a load as recited in claim 51, wherein the temperature differential is provided by a supply of heated fluid and a relatively cold sink, and wherein the supply of heated fluid is heated by a solar collector, and wherein the at least one configurable component further comprises a solar collector adjusting mechanism that adjusts the ability of the solar collector to impart heat to the heated fluid.

58. The apparatus for automatically configuring a thermoelectric power generation system in accordance with the requirements of a load as recited in claim 57, wherein the solar collector is a flat panel solar collector, and wherein the solar collector adjusting mechanism adjusts the position of a shade over the flat panel solar collector.

59. The apparatus for automatically configuring a thermoelectric power generation system in accordance with the requirements of a load as recited in claim 57, wherein the solar collector is a concentrating solar collector, and wherein the solar collector adjusting mechanism adjusts the aiming or focus of the concentrating solar collector.

60. The apparatus for automatically configuring a thermoelectric power generation system in accordance with the requirements of a load as recited in claim 51, wherein the controller is further configured to produce a second signal indicating a status of power being generated by the thermoelectric generator.

61. The apparatus for automatically configuring a thermoelectric power generation system in accordance with the requirements of a load as recited in claim 60, wherein the second signal indicates the amount of power the thermoelectric generator is producing.

62. The apparatus for automatically configuring a thermoelectric power generation system in accordance with the requirements of a load as recited in claim 60, wherein the second signal indicates that the thermoelectric generator is unable to produce power in accordance with the requirements of the load.

63. The apparatus for automatically configuring a thermoelectric power generation system in accordance with the requirements of a load as recited in claim 51, wherein the thermoelectric generator comprises at least two banks, each bank comprising at least one thermoelectric module, and wherein each bank produces a portion of the power produced by the thermoelectric generator.

64. The apparatus for automatically configuring a thermoelectric power generation system in accordance with the requirements of a load as recited in claim 63, wherein the at least one configurable component comprises a matrix switch that, under control of the controller, configures the interconnection of the banks.

65. The apparatus for automatically configuring a thermoelectric power generation system in accordance with the requirements of a load as recited in claim 64, wherein configuring the interconnection of the banks comprises disconnecting at least one bank.

66. The apparatus for automatically configuring a thermoelectric power generation system in accordance with the requirements of a load as recited in claim 64; wherein configuring the interconnection of the banks comprises placing at least one bank in series with at least one other bank.

67. The apparatus for automatically configuring a thermoelectric power generation system in accordance with the requirements of a load as recited in claim 64, wherein configuring the interconnection of the banks comprises placing at least one bank in parallel with at least one other bank.

68. The apparatus for automatically configuring a thermoelectric power generation system in accordance with the requirements of a load as recited in claim 64, wherein configuring the interconnection of the banks comprises placing banks in a combination of series and parallel connections.

69. The apparatus for automatically configuring a thermoelectric power generation system in accordance with the requirements of a load as recited in claim 64, wherein configuring the interconnection of the banks comprises configuring the interconnection of the banks to maintain a desired output voltage for the thermoelectric generator.

70. The apparatus for automatically configuring a thermoelectric power generation system in accordance with the requirements of a load as recited in claim 63, wherein each bank comprises at least two thermoelectric modules, and wherein each thermoelectric module produces a portion of the power produced by its respective bank.

71. The apparatus for automatically configuring a thermoelectric power generation system in accordance with the requirements of a load as recited in claim 70, wherein the at least one configurable component comprises a matrix switch that, under control of the controller, configures the interconnection of the modules within a bank.

72. The apparatus for automatically configuring a thermoelectric power generation system in accordance with the requirements of a load as recited in claim 51, wherein:
the thermoelectric generator comprises at least two banks, wherein each bank produces a portion of the power produced by the thermoelectric generator;
each bank comprises at least two thermoelectric modules, wherein each thermoelectric module produces a portion of the power produced by its respective bank;
each bank comprises a module-level matrix switch that, under control of the controller, configures the interconnection of modules within its respective bank; and
the apparatus further comprises a bank-level matrix switch that, under control of the controller, configures the interconnection of the banks.

73. A method of automatically configuring a thermoelectric power generation system in accordance with the requirements of a load, the method comprising:
receiving, by a controller, at least one signal characterizing the power generated by a thermoelectric generator that generates electric power when subjected to a temperature differential;
receiving, by the controller, an indication of requirements of a load to which power is supplied by the thermoelectric generator;
configuring, by the controller based on the at least one signal characterizing the power generated by the thermoelectric generator and based on the indication of the requirements of the load to which power is supplied by the thermoelectric generator, at least one configurable component that affects at least one aspect of the power generated by the thermoelectric generator.

74. The method of automatically configuring a thermoelectric power generation system in accordance with the requirements of a load as recited in claim 73, wherein the temperature differential is provided by a heated fluid and a relatively cold sink, and wherein configuring the at least one configurable component further comprises adjusting a valve that adjusts a rate of flow of the heated fluid.

75. The method of automatically configuring a thermoelectric power generation system in accordance with the requirements of a load as recited in claim 73, wherein the temperature differential is provided by a heated fluid and a relatively cold sink, and wherein configuring the at least one configurable component further comprises adjusting a valve that adjusts the temperature of the heated fluid.

76. The method of automatically configuring a thermoelectric power generation system in accordance with the requirements of a load as recited in claim 73, wherein the temperature differential is provided by a supply of heated fluid and a relatively cold sink, and wherein the supply of heated fluid is heated by a solar collector, and wherein configuring the at least one configurable component further comprises adjusting the ability of the solar collector to impart heat to the heated fluid.

77. The method of automatically configuring a thermoelectric power generation system in accordance with the requirements of a load as recited in claim 73, wherein the thermoelectric generator comprises at least two banks, each bank comprising at least one thermoelectric module, wherein each bank produces a portion of the power produced by the thermoelectric generator, and wherein configuring the at least one configurable component further comprises controlling a matrix switch to configure the interconnection of the banks.

78. The method of automatically configuring a thermoelectric power generation system in accordance with the requirements of a load as recited in claim 73, wherein the thermoelectric generator comprises at least two thermoelectric modules, wherein each module produces a portion of the power produced by the thermoelectric generator, and wherein configuring the at least one configurable component further comprises controlling a matrix switch to configure the interconnection of the thermoelectric modules.

79. The method of automatically configuring a thermoelectric power generation system in accordance with the requirements of a load as recited in claim 73 wherein the thermoelectric generator comprises at least two banks, each bank comprising at least two thermoelectric modules, wherein each bank produces a portion of the power produced by the thermoelectric generator, wherein each thermoelectric module produces a portion of the power produced by its respective bank, and wherein configuring the at least one configurable component further comprises controlling a module-level matrix switch to configure the interconnection of at least two of the thermoelectric modules, and further comprises controlling a bank-level matrix switch to configure the interconnection of the banks.

80. A method of converting thermal energy stored in a reservoir of heated fluid to electrical energy, the method comprising:
passing heated fluid from the reservoir to a hot side of a thermoelectric generator, the thermoelectric generator comprising a plurality of thermoelectric modules;
cooling a cold side of the thermoelectric generator;
monitoring an output voltage produced by the thermoelectric generator; and
reconfiguring interconnections of the thermoelectric modules to maintain the output voltage within a desired range as the temperature of the heated fluid fluctuates.

81. The method of converting thermal energy stored in a reservoir of heated fluid to electrical energy as recited in claim 80, further comprising heating the heated fluid using a solar collector.

82. The method of converting thermal energy stored in a reservoir of heated fluid to electrical energy as recited in claim 80, wherein the plurality of thermoelectric modules are grouped into banks, and wherein reconfiguring interconnections of the thermoelectric modules to maintain the output voltage within a desired range comprises reconfiguring interconnections of the banks.

83. A system for maintaining a power characteristic within a predetermined range, the system comprising:
a monitor that measures a characteristic of power being supplied to a load by a thermoelectric generator;
a controller that receives a signal from the monitor, the signal communicating the measurement of the power characteristic, the controller also including a specification of a predetermined desired range for the power characteristic; and
a matrix switch having a plurality of input connections, the input terminals receiving connections from a plurality of thermoelectric modules within the thermoelectric generator, and the matrix switch further comprising a set of output terminals through which power generated by the thermoelectric generator is delivered to the load;
wherein the controller is configured to compare the measurement of the power characteristic with the predetermined range, and to reconfigure interconnections between the input terminals and the output terminals to keep the power characteristic within the predetermined range.

84. The system for maintaining a power characteristic within a predetermined range as recited in claim 83, wherein the predetermined characteristic is a voltage.

85. The system for maintaining a power characteristic within a predetermined range as recited in claim 83, wherein the controller further comprises a microprocessor executing instructions stored on a computer-readable medium.

86. A thermoelectric generator for generating electrical power from a difference in temperature, the thermoelectric generator comprising:
a plurality of thermoelectric modules, each thermoelectric module having a first side and a second side, and each thermoelectric module generating electrical power when subjected to a temperature differential between its respective first side and second side;
a plurality of first thermal elements to which heat is supplied by a first fluid;
a plurality of second thermal elements from which heat is removed by a second fluid;
wherein the first and second thermal elements are arranged in a stack of alternating first and second thermal elements having one of the plurality of thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules.

87. The thermoelectric generator for generating electrical power from a difference in temperature as recited in claim 86, wherein each of the first and second thermal elements is a block made of a thermally conductive material, each block further comprising a passageway through the block through which the respective fluid flows.

88. The thermoelectric generator for generating electrical power from a difference in temperature as recited in claim 87, wherein the thermally conductive material is aluminum.

89. The thermoelectric generator for generating electrical power from a difference in temperature as recited in claim 87, wherein each block is generally rectangular, and wherein each passageway traverses its respective block generally diagonally.

90. The thermoelectric generator for generating electrical power from a difference in temperature as recited in claim 87, wherein each passageway comprises a lead-in portion at each end of the passageway, each lead-in portion being generally cylindrical and of a larger dimension than the midportion of the passageway.

91. The thermoelectric generator for generating electrical power from a difference in temperature as recited in claim 86, wherein the first and second thermal elements are mechanically interchangeable.

92. The thermoelectric generator for generating electrical power from a difference in temperature as recited in claim 86, further comprising a clamp that holds the stack of thermoelectric modules and first and second thermal elements in compression.

93. The thermoelectric generator for generating electrical power from a difference in temperature as recited in claim 86, further comprising:
a first fluid inlet manifold that distributes the first fluid to the first thermal elements; and
a first fluid outlet manifold that collects the first fluid from the first thermal elements.

94. The thermoelectric generator for generating electrical power from a difference in temperature as recited in claim 86 , further comprising:
a second fluid inlet manifold that distributes the second fluid to the second thermal elements; and
a second fluid outlet manifold that collects the second fluid from the second thermal elements.

95. The thermoelectric generator for generating electrical power from a difference in temperature as recited in claim 86, further comprising:
a first fluid inlet manifold that distributes the first fluid to the first thermal elements;
a first fluid outlet manifold that collects the first fluid from the first thermal elements;
a second fluid inlet manifold that distributes the second fluid to the second thermal elements; and
a second fluid outlet manifold that collects the second fluid from the second thermal elements.

96. The thermoelectric generator for generating electrical power from a difference in temperature as recited in claim 95, wherein the first fluid inlet manifold and the second fluid outlet manifold are positioned adjacent each other on one side of the stack of thermoelectric modules and first and second thermal elements.

97. The thermoelectric generator for generating electrical power from a difference in temperature as recited in claim 95, further comprising one or more flexible tubes, at least one of the tubes connecting each of the manifolds with each of its respective first or second thermal elements.

98. The thermoelectric generator for generating electrical power from a difference in temperature as recited in claim 97, wherein at least one of the flexible tubes is press fit into its respective manifold and thermal element.

99. The thermoelectric generator for generating electrical power from a difference in temperature as recited in claim 86, wherein the first fluid is water.

100. The thermoelectric generator for generating electrical power from a difference in temperature as recited in claim 86, wherein the second fluid is water.

101. A method of fabricating a thermoelectric generator for generating electrical power from a difference in temperature, the method comprising:
providing a plurality of thermoelectric modules, each thermoelectric module having a first side and a second side, and each thermoelectric module generating electrical power when subjected to a temperature differential between its respective first side and second side;
providing a plurality of first thermal elements configured to receive heat from a first fluid;
providing a plurality of second thermal elements configured to be cooled by a second fluid;
arranging the first and second thermal elements in a stack of alternating first and second thermal elements having one of the thermoelectric modules between each adjacent pair of first and second thermal elements, each thermoelectric module in contact on its first side with one of the first thermal elements and in contact on its second side with one of the second thermal elements such that no face of any thermal element contacts more than one of the thermoelectric modules.

102. The method of fabricating a thermoelectric generator for generating electrical power from a difference in temperature as recited in claim 101, the method further comprising:
providing a first fluid inlet manifold configured to receive the first fluid and distribute it to the plurality of first thermal elements.

103. The method of fabricating a thermoelectric generator for generating electrical power from a difference in temperature as recited in claim 101, the method further comprising:
providing a second fluid inlet manifold configured to receive the second fluid and distribute it to the plurality of second thermal elements.

104. The method of fabricating a thermoelectric generator for generating electrical power from a difference in temperature as recited in claim 101, the method further comprising:
providing a first fluid outlet manifold configured to receive the first fluid from the plurality of first thermal elements and carry the first fluid away from the thermoelectric generator.

105. The method of fabricating a thermoelectric generator for generating electrical power from a difference in temperature as recited in claim 101, the method further comprising:
providing a second fluid outlet manifold configured to receive the second fluid from the plurality of second thermal elements and carry the second fluid away from the thermoelectric generator.

106. The method of fabricating a thermoelectric generator for generating electrical power from a difference in temperature as recited in claim 101, the method further comprising:
connecting each thermal element to a fluid inlet manifold and to a fluid outlet manifold.

107. The method of fabricating a thermoelectric generator for generating electrical power from a difference in temperature as recited in claim 101, the method further comprising:
clamping the stack of first thermal elements, second thermal elements, and thermoelectric modules, so that that stack is held in compression.
